# EUROPEAN PATENT APPLICATION

(11) **EP 4 685 608 A1**
(43) Date of publication of application: **28.01.2026**
(21) Application number: 24797533.7
(22) Date of filing: 16.04.2024
(51) Int. Cl.: G06F 1/16, H04M 1/02, F16C 11/04

(54) **ELECTRONIC APPARATUS INCLUDING HINGE DEVICE**

(30) Priority: 24.04.2023 KR 20230053279; 23.05.2023 KR 20230066173
(71) Applicant: Samsung Electronics Co., Ltd., Suwon-si, Gyeonggi-do 16677 (KR)
(72) Inventor: KIM, Yoonsik, Suwon-si, Gyeonggi-do 16677 (KR)
(74) Representative: HGF
(86) International application number: PCT/KR2024/095742
(87) International publication number: WO 2024/225881

(57) **Abstract**

A hinge device according to an embodiment of the present invention may comprise: a bracket that includes a first connection part and a second connection part spaced apart from the first connection part; a first rotator that includes a first rotating part connected to a first connection part of the bracket and rotating relative to the bracket, and a first cam structure formed on the first rotating part; a second rotator that includes a second rotating part connected to the second connection part of the bracket and rotating relative to the bracket, and a second cam structure formed on the second rotating part; a cam slide that is disposed on the bracket, includes a first cam part engaging with the first cam structure and a second cam part engaging with the second cam structure, and moves in the first axial direction according to the rotation of the first rotator and the second rotator; an elastic member that is disposed between the cam slide and one surface of the bracket and presses the cam slide in a first direction; and a shock-absorbing member that is made of a different material than the elastic member and is disposed between the cam slide and the one surface of the bracket and presses the cam slide in the first direction. Various other embodiments are also possible.

## Description

### [Technical Field]

Various embodiments disclosed in this document relate to an electronic device including a hinge device.

### [Background Art]

As information displayed visually increases and electronic devices support more functions, users who want larger screen displays are increasing. New types of electronic devices for providing large screen displays while maintaining a portable size are also being developed. As display technology advances, foldable displays have become possible. Electronic devices having variable areas that may display information by folding using these displays are also being released.

### [Disclosure of Invention]

### [Technical Problem]

An electronic device may be a foldable electronic device including a first housing, a second housing, and a hinge device (e.g., hinge module or hinge assembly) for connecting the first housing and the second housing. The first housing and the second housing are structurally coupled to the hinge device, thereby ensuring operational reliability for a folded state and/or an unfolded state. Such a foldable electronic device may operate in an in-folding method and/or an out-folding method by allowing the first housing to rotate with respect to the second housing in a range of 0 degrees to 360 degrees through the hinge device.

The hinge device may include a pair of rotators connected to a first housing and a second housing and having a cam structure, a cam slide including a cam part disposed on the same rotational axis as that of the pair of rotators and disposed to face the cam structure formed in the pair of rotators, and an elastic member for providing a pressing force for cam coupling by pressing the cam slide in the direction of the pair of rotators. In an embodiment, a cam structure formed in the pair of rotators and a cam part formed in the cam slide may be interlocked according to folding and unfolding operations of the electronic device. Further, a frictional force may occur between the cam structure formed in the pair of rotators and the cam part formed in the cam slide through an elastic member. Such a cam coupling structure may provide a free stop function that may stop at a designated angle during folding and unfolding operations of the first housing and the second housing, or may provide a detent force that may maintain the electronic device in a folded state or an unfolded state.

As the thickness of the electronic device is reduced, the thickness of the hinge device may be also reduced. For example, the thickness of an elastic member providing a contact force between a pair of rotators and a cam slide may be reduced. In this case, a pressing force through the elastic member may be reduced; thus, free stop that allows the electronic device to stop at a specific angle may not be implemented. Further, a detent force that maintains the electronic device in a folded state or an unfolded state is weakened; thus, the electronic device may be switched from a folded state to an unfolded state or from an unfolded state to a folded state regardless of the user's intention.

### [Solution to Problem]

According to an embodiment of the disclosure, a hinge device may include a bracket including a first coupling part and a second coupling part spaced apart from the first coupling part; a first rotator including a first rotation part fastened to the first coupling part of the bracket to rotate with respect to the bracket, and a first cam structure formed in the first rotation part; a second rotator including a second rotation part fastened to the second coupling part of the bracket to rotate with respect to the bracket, and a second cam structure formed in the second rotation part; a cam slide including a first cam part disposed in the bracket and configured to engage with the first cam structure and a second cam part configured to engage with the second cam structure, and configured to move in a first axial direction according to the rotation of the first rotator and the second rotator; elastic members disposed between one surface of the bracket and the cam slide to press the cam slide in the first direction; and a buffer member made of a material different from that of the elastic member and disposed between one surface of the bracket and the cam slide to press the cam slide in a first direction.

According to an embodiment of the disclosure, an electronic device may include a first housing; a second housing; and a hinge device configured to foldably connect the first housing and the second housing, wherein the hinge device may include a bracket including a first coupling part and a second coupling part spaced apart from the first coupling part; a first rotator including a first rotation part fastened to the first coupling part of the bracket to rotate with respect to the bracket, and a first cam structure formed in the first rotation part; a second rotator including a second rotation part fastened to the second coupling part of the bracket to rotate with respect to the bracket, and a second cam structure formed in the second rotation part; a cam slide including a first cam part disposed in the bracket and configured to engage with the first cam structure and a second cam part configured to engage with the second cam structure, and configured to move in a first axial direction according to the rotation of the first rotator and the second rotator; elastic members disposed between one surface of the bracket and the cam slide to press the cam slide in a first direction; and a buffer member made of a material different from that of the elastic member and disposed between one surface of the bracket and the cam slide to press the cam slide in the first direction.

### [Advantageous Effects of Invention]

According to an embodiment disclosed in this document, a hinge device can increase a pressing force operating between a rotator and a cam slide through an additional elastic member. Accordingly, the electronic device can maintain free stop, an unfolded state, and/or a folded state at a specific angle.

Further, the operational feel of the hinge device can be improved by damping vibrations generated according to the operation of the hinge device through an additional elastic member.

### [Brief Description of Drawings]

In connection with the description of the drawings, the same or similar reference numerals may be used for the same or similar components.
FIGS. 1A and 1B are front and rear views illustrating an unfolded state of an electronic device according to various embodiments of the disclosure.
FIGS. 2A and 2B are front and rear views illustrating a folded state of an electronic device according to various embodiments of the disclosure.
FIG. 3 is an exploded perspective view illustrating an electronic device according to an embodiment of the disclosure.
FIG. 4 is an exploded perspective view illustrating a hinge device according to an embodiment of the disclosure.
FIG. 5A is a perspective view illustrating a front surface of a hinge device according to an embodiment of the disclosure.
FIG. 5B is a perspective view illustrating a rear surface of a hinge device according to an embodiment of the disclosure.
FIG. 6A is a diagram illustrating a coupling relationship between a cam slide and a buffer member according to an embodiment of the disclosure.
FIG. 6B is a cross-sectional view taken along line A-A of FIG. 6A.
FIG. 7A is a diagram illustrating the interlocking relationship between a cam part of a cam slide and a cam structure of a pair of rotators according to an unfolded state of the electronic device.
FIG. 7B is a diagram illustrating the interlocking relationship between a cam part of a cam slide and a cam structure of a pair of rotators according to an intermediate state of an electronic device.
FIG. 7C is a diagram illustrating the interlocking relationship between a cam part of a cam slide and a cam structure of a pair of rotators according to a folded state of an electronic device.
FIG. 8A is a diagram illustrating a compression state of a buffer member according to the linear movement of the cam slide in FIG. 7A.
FIG. 8B is a diagram illustrating a compression state of a buffer member according to the linear movement of the cam slide in FIG. 7B.
FIG. 8C is a diagram illustrating a compression state of a buffer member according to the linear movement of the cam slide in FIG. 7C.
FIGS. 9A and 9B are diagrams illustrating an embodiment in which a protruding part is formed in a buffer member according to an embodiment of the disclosure.
FIGS. 10A, 10B, 11A, 11B, 12A, and 12B are diagrams illustrating an embodiment in which a slit is formed in a buffer member according to an embodiment of the disclosure.
FIGS. 13A and 13B are diagrams illustrating an embodiment in which an inner part and an outer part of a buffer member are made of different materials according to an embodiment of the disclosure.
FIG. 14A is a graph illustrating vibrations occurring in a hinge device in a state in which no buffer member is disposed in the hinge device according to an embodiment of the disclosure.
FIG. 14B is a graph illustrating vibrations occurring in a hinge device in a state in which a buffer member is disposed in the hinge device according to an embodiment of the disclosure.

### [Mode for the Invention]

In the following description, various embodiments of this document are described with reference to the attached drawings. It should be understood that various embodiments of this document and terms used therein are not intended to limit technical features described in this document to specific embodiments, but include various modifications, equivalents, or substitutes of the embodiments.

In connection with the description of the drawings, similar reference numerals may be used for similar or related components. The singular form of the noun corresponding to the item may include one or more of the item, unless the relevant context clearly dictates otherwise.

In this document, each of phrases such as "A or B", "at least one of A and B", "at least one of A or B", "A, B, or C", "at least one of A, B, and C", and "at least one of A, B, or C" may include any one of or all possible combinations of items listed together in the corresponding one of the phrases. Terms such as "first" or "second" may be simply used for distinguishing a corresponding component from other corresponding components, and do not limit the corresponding components in other aspects (e.g., importance or order). In the case that one (e.g., first) component is referred to as "coupled" or "connected" to another (e.g., second) component, with or without the terms "functionally" or "communicatively", it means that the one component may be connected to the other component directly (e.g., by wire), wirelessly, or through a third component.

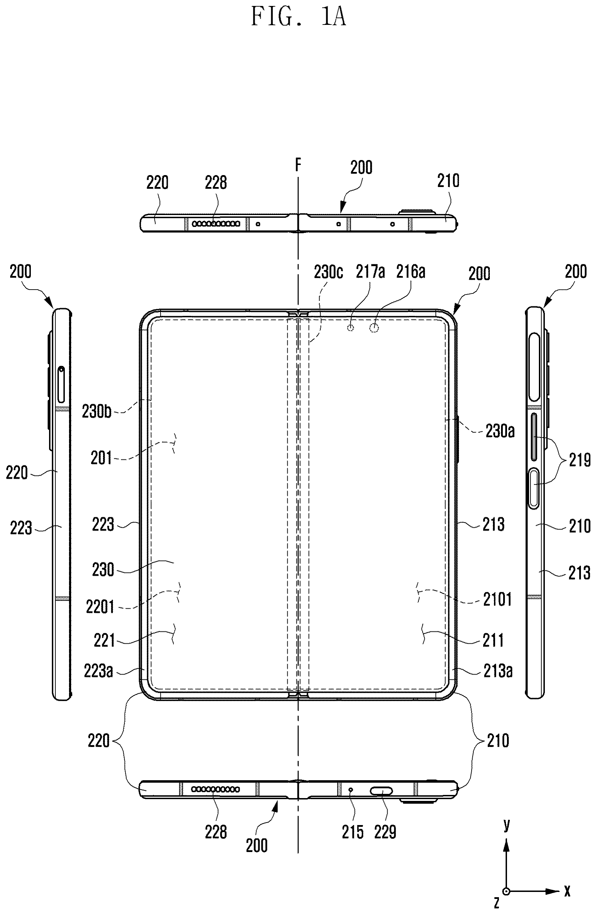

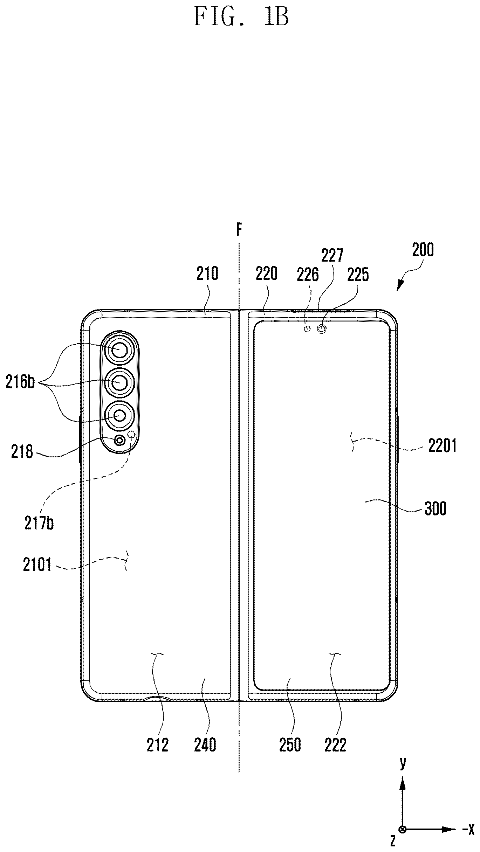

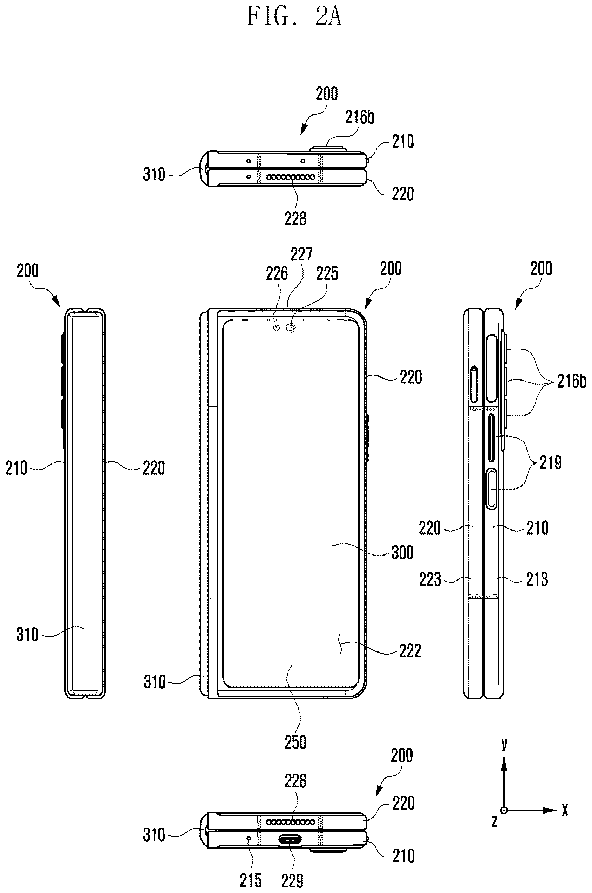

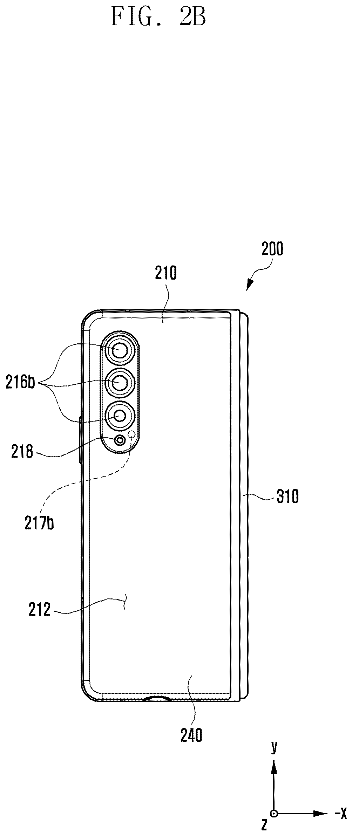

FIGS. 1A and 1B are front and rear views illustrating an unfolded state of an electronic device according to various embodiments of the disclosure. FIGS. 2A and 2B are front and rear views illustrating a folded state of an electronic device according to various embodiments of the disclosure.

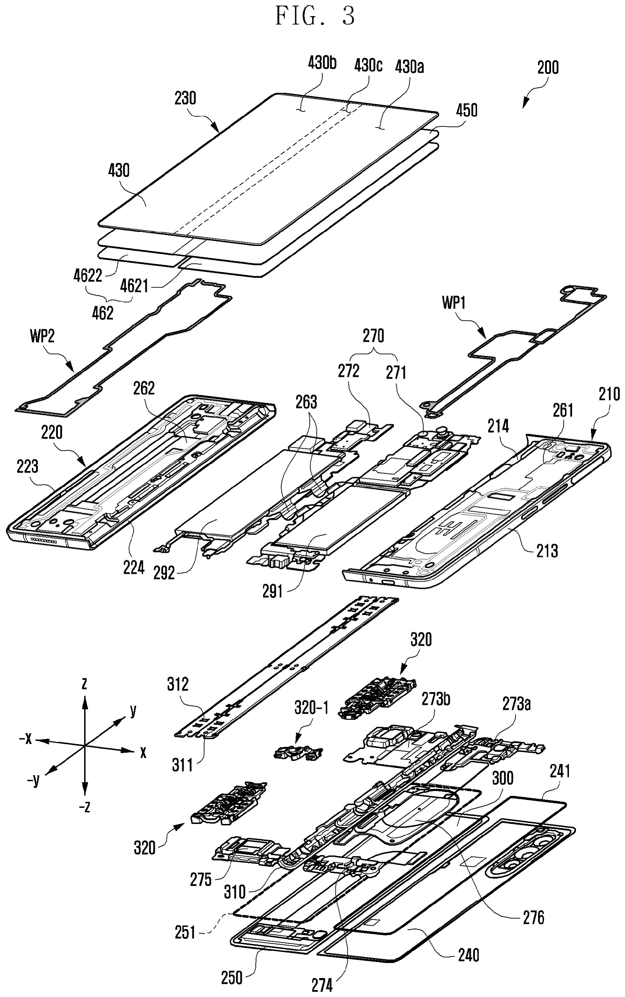

With reference to FIGS. 1A to 2B, an electronic device 200 may include a pair of housings 210 and 220 (e.g., foldable housing structure) rotatably coupled based on a folding axis F through at least one hinge device (e.g., a hinge device 320 of FIG. 3) (e.g., hinge module or hinge structure) so as to be foldable with respect to each other, a first display 230 (e.g., flexible display, foldable display, or main display) disposed through the pair of housings 210 and 220, and/or a second display 300 (e.g., sub-display) disposed through the second housing 220. In an embodiment, at least one hinge device (e.g., a hinge device 320 of FIG. 3) may be disposed to be invisible from the outside through at least part of the first housing 210 and the second housing 220, and be disposed to be invisible from the outside through a hinge housing 310 (e.g., hinge cover) that covers the foldable portion in an unfolded state. In this document, a surface in which the first display 230 is disposed may be defined as a front surface of the electronic device 200, and a surface opposite to the front surface may be defined as a rear surface of the electronic device 200. Further, a surface enclosing a space between the front surface and the rear surface may be defined as a side surface of the electronic device 200.

According to an embodiment, the pair of housings 210 and 220 may include a first housing 210 and a second housing 220 foldably disposed with respect to each other through at least one hinge device (e.g., the hinge device 320 of FIG. 3). In an embodiment, the pair of housings 210 and 220 are not limited to shapes and coupling illustrated in FIGS. 1A to 2B, but may be implemented by combinations and/or coupling of other shapes or parts. In an embodiment, the first housing 210 and the second housing 220 may be disposed at both sides based on a folding axis F, have an overall symmetrical shape with respect to the folding axis F, and be folded to match each other. According to some embodiments, the first housing 210 and the second housing 220 may be folded asymmetrically based on the folding axis F. In an embodiment, the first housing 210 and the second housing 220 may have different angles or distances with respect to each other according to whether the electronic device 200 is in an unfolded state, a folded state, or an intermediate state.

According to an embodiment, the first housing 210 may include a first surface 211 connected to at least one hinge device (e.g., a hinge device 320 of FIG. 3) in an unfolded state of the electronic device 200 and disposed to face the front surface of the electronic device 200, a second surface 212 that faces in an opposite direction to that of the first surface 211, and/or a first lateral member 213 that encloses at least a portion of a first space 2101 between the first surface 211 and the second surface 212. In an embodiment, the second housing 220 may include a third surface 221 connected to at least one hinge device (e.g., the hinge device 320 of FIG. 3) and disposed to face the front surface of the electronic device 200 in an unfolded state of the electronic device 200, a fourth surface 222 that faces in an opposite direction to that of the third surface 221, and/or a second lateral member 223 that encloses at least a portion of a second space 2201 between the third surface 221 and the fourth surface 222. In an embodiment, the first surface 211 may face substantially the same direction as that of the third surface 221 in an unfolded state of the electronic device 200, and at least partially face the third surface 221 in a folded state of the electronic device 200. In an embodiment, the electronic device 200 may include a recess 201 formed to receive the first display 230 through structural coupling of the first housing 210 and the second housing 220. In an embodiment, the recess 201 may have substantially the same size as that of the first display 230. In an embodiment, the first housing 210 may include a first protective frame 213a (e.g., first decorative member) coupled to the first lateral member 213 and disposed to overlap with an edge of the first display 230 when the first display 230 is viewed from above, thereby covering an edge of the first display 230 to be invisible from the outside. In an embodiment, the first protective frame 213a may be formed integrally with the first lateral member 213. In an embodiment, the second housing 220 may include a second protective frame 223a (e.g., second decorative member) coupled to the second lateral member 223 when the first display 230 is viewed from above and disposed to overlap with an edge of the first display 230, thereby covering the edge of the first display 230 to be invisible from the outside. In an embodiment, the second protective frame 223a may be formed integrally with the second lateral member 223. In some embodiments, the first protective frame 213a and the second protective frame 223a may be omitted.

According to an embodiment, the hinge housing 310 (e.g., hinge cover) may be disposed between the first housing 210 and the second housing 220 and be disposed to cover a portion of at least one hinge device (e.g., the hinge device 320 of FIG. 3). In an embodiment, the hinge housing 310 may be covered by a portion of the first housing 210 and the second housing 220 or exposed to the outside according to an unfolded state, a folded state, or an intermediate state of the electronic device 200. For example, in the case that the electronic device 200 is in the unfolded state, at least a portion of the hinge housing 310 may be covered by the first housing 210 and the second housing 220 to be disposed to be substantially invisible from the outside. In an embodiment, in the case that the electronic device 200 is in a folded state, at least a portion of the hinge housing 310 may be disposed to be visible from the outside between the first housing 210 and the second housing 220. In an embodiment, in the case that the first housing 210 and the second housing 220 are in an intermediate state where they are folded with a certain angle, the hinge housing 310 may be disposed to be visible at least partially from the outside of the electronic device 200 between the first housing 210 and the second housing 220. For example, an area of the hinge housing 310 exposed to the outside may be smaller than that in a completely folded state. In an embodiment, the hinge housing 310 may include a curved surface.

According to an embodiment, in the case that the electronic device 200 is in an unfolded state (e.g., the state of FIGS. 1A and 1B), the first housing 210 and the second housing 220 form an angle of about 180 degrees, and a first area 230a, a second area 230b, and a folding area 230c of the first display 230 may be disposed to substantially form the same plane and face the same direction (e.g., z-axis direction). According to an embodiment, in the case that the electronic device 200 is in an unfolded state, the first housing 210 may rotate at an angle of about 360 degrees with respect to the second housing 220 and be folded in the opposite direction so that the second surface 212 and the fourth surface 222 face each other (out folding method).

According to an embodiment, in the case that the electronic device 200 is in a folded state (e.g., the state of FIGS. 2A and 2B), the first surface 211 of the first housing 210 and the third surface 221 of the second housing 220 may be disposed to face each other. In this case, the first area 230a and the second area 230b of the first display 230 may be disposed to face each other while forming a narrow angle (e.g., the range of 0 degrees to about 10 degrees) with respect to each other through the folding area 230c. In an embodiment, at least a portion of the folding area 230c may be transformed into a curved shape having a certain curvature. In an embodiment, in the case that the electronic device 200 is in an intermediate state, the first housing 210 and the second housing 220 may be disposed at a certain angle with respect to each other. In this case, the first area 230a and the second area 230b of the first display 230 may form an angle larger than that of the folded state and smaller than that of the unfolded state, and the curvature of the folding area 230c may be smaller than that of the folded state and larger than that of the unfolded state. In some embodiments, the first housing 210 and the second housing 220 may form an angle that may stop at a designated folding angle between the folded state and the unfolded state through at least one hinge device (e.g., the hinge device 320 of FIG. 3) (free stop function). In some embodiments, the first housing 210 and the second housing 220 may continuously operate while being pressed in the unfolding direction or the folding direction based on a designated inflection angle through at least one hinge device (e.g., the hinge device 320 of FIG. 3).

According to an embodiment, the electronic device 200 may include at least one of at least one display 230 and 300, an input device 215, sound output devices 227 and 228, sensor modules 217a, 217b, and 226, camera modules 216a, 216b, and 225, a key input device 219, an indicator (not illustrated), or a connector port 229 disposed in the first housing 210 and/or the second housing 220. In some embodiments, the electronic device 200 may omit at least one of the components or may additionally include at least one other component.

According to an embodiment, at least one display 230 and 300 may include a first display 230 (e.g., flexible display) disposed to be supported by the third surface 221 of the second housing 220 from the first surface 211 of the first housing 210, and a second display 300 disposed to be at least partially visible from the outside through the fourth surface 222 in an internal space of the second housing 220. In some embodiments, the second display 300 may be disposed to be visible from the outside through the second surface 212 in an internal space of the first housing 210. In an embodiment, the first display 230 may be primarily used in an unfolded state of the electronic device 200, and the second display 300 may be primarily used in a folded state of the electronic device 200. In an embodiment, the electronic device 200 may control the use of the first display 230 and/or the second display 300 based on the folding angle of the first housing 210 and the second housing 220 in an intermediate state.

According to an embodiment, the first display 230 may be disposed in a receiving space formed by a pair of housings 210 and 220. For example, the first display 230 may be disposed in the recess 201 formed by a pair of housings 210 and 220 and be disposed to occupy substantially most of the front surface of the electronic device 200 in an unfolded state. In an embodiment, the first display 230 may include a flexible display whose at least a partial area may be transformed into a flat surface or a curved surface. In an embodiment, the first display 230 may include a first area 230a facing the first housing 210 and a second area 230b facing the second housing 220. In an embodiment, the first display 230 may include a folding area 230c including a portion of the first area 230a and a portion of the second area 230b based on the folding axis F. In an embodiment, at least a portion of the folding area 230c may include an area corresponding to at least one hinge device (e.g., the hinge device 320 of FIG. 3). In an embodiment, the area division of the first display 230 is merely an exemplary division by a pair of housings 210 and 220 and at least one hinge device (e.g., the hinge device 320 of FIG. 3), and substantially, the first display 230 may be displayed as a seamless full screen through a pair of housings 210 and 220 and at least one hinge device (e.g., the hinge device 320 of FIG. 3). In an embodiment, the first area 230a and the second area 230b may have an overall symmetrical shape based on the folding area 230c or may have a partially asymmetrical shape.

According to an embodiment, the electronic device 200 may include a first rear cover 240 disposed at the second surface 212 of the first housing 210 and a second rear cover 250 disposed at the fourth surface 222 of the second housing 220. In some embodiments, at least a portion of the first rear cover 240 may be formed integrally with the first lateral member 213. In some embodiments, at least a portion of the second rear cover 250 may be formed integrally with the second lateral member 223. In an embodiment, at least one of the first rear cover 240 and the second rear cover 250 may be formed with a substantially transparent plate (e.g., a polymer plate, or a glass plate including various coating layers) or an opaque plate. In an embodiment, the first rear cover 240 may be formed by an opaque plate such as coated or colored glass, ceramic, polymer, metal (e.g., aluminum, stainless steel (STS), or magnesium), or a combination of at least two of the foregoing materials. In an embodiment, the second rear cover 250 may be formed through a substantially transparent plate such as glass or polymer. Accordingly, the second display 300 may be disposed to be visible from the outside through the second rear cover 250 in the internal space of the second housing 220.

According to an embodiment, the input device 215 may include a microphone. In some embodiments, the input device 215 may include a plurality of microphones disposed to detect the direction of sound. In an embodiment, the sound output devices 227 and 228 may include speakers. In an embodiment, the sound output devices 227 and 228 may include a call receiver 227 disposed through the fourth surface 222 of the second housing 220 and an external speaker 228 disposed through at least a portion of the second lateral member 223 of the second housing 220. In some embodiments, the input device 215, the sound output devices 227 and 228, and the connector 229 may be disposed in spaces of the first housing 210 and/or the second housing 220 and be exposed to the external environment through at least one hole formed in the first housing 210 and/or the second housing 220. In some embodiments, holes formed in the first housing 210 and/or the second housing 220 may be used in common for the input device 215 and the sound output devices 227 and 228. In some embodiments, the sound output devices 227 and 228 may include a speaker (e.g., piezo speaker) that operates without holes formed in the first housing 210 and/or the second housing 220.

According to an embodiment, the camera modules 216a, 216b, and 225 may include a first camera module 216a disposed at the first surface 211 of the first housing 210, a second camera module 216b disposed at the second surface 212 of the first housing 210, and/or a third camera module 225 disposed at the fourth surface 222 of the second housing 220. In an embodiment, the electronic device 200 may include a flash 218 disposed near the second camera module 216b. In an embodiment, the flash 218 may include, for example, a light emitting diode or a xenon lamp. In an embodiment, the camera modules 216a, 216b, and 225 may include one or more lenses, an image sensor, and/or an image signal processor. In some embodiments, at least one of the camera modules 216a, 216b, and 225 may include two or more lenses (e.g., wide angle and telephoto lens) and image sensors, and be disposed together at either surface of the first housing 210 and/or the second housing 220.

According to an embodiment, the sensor modules 217a, 217b, and 226 may generate electrical signals or data values corresponding to an internal operating state of the electronic device 200 or an external environmental state. In an embodiment, the sensor modules 217a, 217b, and 226 may include a first sensor module 217a disposed at the first surface 211 of the first housing 210, a second sensor module 217b disposed at the second surface 212 of the first housing 210, and/or a third sensor module 226 disposed at the fourth surface 222 of the second housing 220. In some embodiments, the sensor modules 217a, 217b, and 226 may include at least one of a gesture sensor, a grip sensor, a color sensor, an infrared (IR) sensor, an illuminance sensor, an ultrasonic sensor, an iris recognition sensor, or a distance detection sensor (e.g., time of flight (TOF) sensor or light detection and ranging (LiDAR) sensor).

According to an embodiment, the electronic device 200 may further include a sensor module (not illustrated), for example, at least one of an atmospheric pressure sensor, a magnetic sensor, a biometric sensor, a temperature sensor, a humidity sensor, or a fingerprint recognition sensor. In some embodiments, the fingerprint recognition sensor may be disposed through at least one of the first lateral member 213 of the first housing 210 and/or the second lateral member 223 of the second housing 220.

According to an embodiment, the key input device 219 may be disposed to be exposed to the outside through the first lateral member 213 of the first housing 210. In some embodiments, the key input device 219 may be disposed to be exposed to the outside through the second lateral member 223 of the second housing 220. In some embodiments, the electronic device 200 may not include some or all of the key input devices 219, and the key input devices 219 that are not included may be implemented in another form, such as a soft key, on at least one display 230 and 300. According to an embodiment, the key input device 219 may be implemented using a pressure sensor included in at least one display 230 and 300.

According to an embodiment, the connector port 229 may include a connector (e.g., USB connector or interface connector port module (IF module)) for transmitting and receiving power and/or data to and from an external electronic device. In some embodiments, the connector port 229 may perform a function for transmitting and receiving audio signals to and from the external electronic device, or may further include a separate connector port (e.g., ear jack hole) for performing a function for transmitting and receiving audio signals.

According to an embodiment, at least one camera module 216a and 225 of the camera modules 216a, 216b, and 225, at least one sensor module 217a and 226 of the sensor modules 217a, 217b, and 226, and/or an indicator may be disposed to be exposed through at least one display 230 and 300. For example, at least one camera module 216a and 225, at least one sensor module 217a and 226, and/or the indicator may be disposed under an active area (display area) of at least one display 230 and 300 in an internal space of at least one housing 210 and 220, and be disposed to contact an external environment through an opening or transparent area perforated up to a cover member (e.g., window layer (not illustrated) of the first display 230 and/or the second rear cover 250). In an embodiment, an area where at least one display 230 and 300 and at least one camera module 216a and 225 face each other may be formed as a transparent area having a predetermined transmittance as part of an area displaying content. In an embodiment, the transparent area may be formed to have a transmittance in a range of about 5% to about 20%. Such a transparent area may include an area overlapped with an effective area (e.g., field of view area) of at least one camera module 216a and 225 through which light passes to be imaged by an image sensor to generate an image. For example, the transparent area of the displays 230 and 300 may include an area having a lower pixel density than that of a peripheral area. For example, the transparent area may replace an opening. For example, at least one camera module 216a and 225 may include an under display camera (UDC) or an under panel camera (UPC). According to an embodiment, some camera modules or sensor modules 217a and 226 may be disposed to perform functions thereof without being visually exposed through the display. For example, an area facing the camera modules 216a and 225 and/or the sensor modules 217a and 226 disposed under the displays 230 and 300 (e.g., display panel) may have an under display camera (UDC) structure, whereby a perforated opening may not be necessary.

FIG. 3 is an exploded perspective view illustrating an electronic device according to various embodiments of the disclosure.

With reference to FIG. 3, the electronic device 200 may include a first display 230 (e.g., flexible display), a second display 300, at least one hinge device 320, a pair of support members 261 and 262, at least one substrate 270 (e.g., printed circuit board (PCB)), a first housing 210, a second housing 220, a first rear cover 240, and/or a second rear cover 250.

According to an embodiment, the first display 230 may include a display panel 430 (e.g., flexible display panel) and a support plate 450 disposed under the display panel 430. In an embodiment, the first display 230 may include a reinforcing plate 462 disposed under the support plate 450. In some embodiments, the reinforcing plates 462 may be omitted. In an embodiment, the display panel 430 may include a first panel area 430a corresponding to a first area (e.g., the first area 230a of FIG. 1A) of the first display 230, a second panel area 430b extended from the first panel area 430a and corresponding to a second area (e.g., the second area 230b of FIG. 1A) of the first display 230, and a third panel area 430c connecting the first panel area 430a and the second panel area 430b and corresponding to a folding area (e.g., the folding area 230c of FIG. 1A) of the first display 230. In an embodiment, the support plate 450 may be disposed between the display panel 430 and the pair of support members 261 and 262 and be formed to have a material and shape for providing a planar support structure for the first panel area 430a and the second panel area 430b and a bendable structure for assisting in bendability for the third panel area 430c. In an embodiment, the support plate 450 may be made of a conductive material (e.g., metal) or a non-conductive material (e.g., polymer or fiber reinforced plastics (FRP)). In an embodiment, the reinforcing plate 462 may include a first reinforcing plate 4621 disposed between the support plate 450 and the pair of support members 261 and 262 to correspond with at least a portion of the first panel area 430a and the third panel area 430c, and a second reinforcing plate 4622 disposed to correspond with at least a portion of the second panel area 430b and the third panel area 430c. In an embodiment, the reinforcing plate 462 may be made of a metal material (e.g., SUS), thereby assisting in a ground connection structure and rigidity reinforcement for the first display 230. In some embodiments, the electronic device 200 may include a digitizer disposed under the support plate 450 and replaced with the reinforcing plate 462 or added between the support plate 450 and the reinforcing plate 462.

According to an embodiment, the second display 300 may be disposed in the space between the second housing 220 and the second rear cover 250. In an embodiment, the second display 300 may be disposed to be visible from the outside through substantially the entire area of the second rear cover 250 in the space between the second housing 220 and the second rear cover 250.

According to an embodiment, at least a portion of the first support member 261 may be foldably coupled to the second support member 262 through at least one hinge device 320. In an embodiment, the electronic device 200 may include at least one wiring member 263 (e.g., flexible printed circuit board (FPCB)) disposed from at least a portion of the first support member 261 to a portion of the second support member 262 across at least one hinge device 320. In an embodiment, the first support member 261 may be disposed in a manner extended from the first lateral member 213 or structurally coupled with the first lateral member 213. In an embodiment, the electronic device 200 may include a first space (e.g., the first space 2101 of FIG. 1A) provided through the first support member 261 and the first rear cover 240. In an embodiment, the first housing 210 (e.g., first housing structure) may be constituted by coupling the first lateral member 213, the first support member 261, and the first rear cover 240. In an embodiment, the second support member 262 may be disposed in a manner extended from the second lateral member 223 or structurally coupled with the second lateral member 223. In an embodiment, the electronic device 200 may include a second space (e.g., the second space 2201 of FIG. 1A) provided by the second support member 262 and the second rear cover 250. In an embodiment, the second housing 220 (e.g., second housing structure) may be constituted by coupling the second lateral member 223, the second support member 262, and the second rear cover 250. In an embodiment, at least a portion of at least one wiring member 263 and/or the at least one hinge device 320 may be disposed to be supported by at least a portion of a pair of support members 261 and 262. In an embodiment, at least one wiring member 263 may be disposed to be extended from the first support member 261 to the second support member 262 across the folding axis F. In an embodiment, at least one wiring member 263 may be disposed to have a length in a direction (e.g., x-axis direction) substantially perpendicular to the folding axis (e.g., y-axis or the folding axis F of FIG. 1A).

According to an embodiment, at least one substrate 270 may include a first substrate 271 disposed in the first space 2101 and a second substrate 272 disposed in the second space 2201. In an embodiment, the first substrate 271 and the second substrate 272 may include a plurality of electronic components disposed to implement various functions of the electronic device 200. In an embodiment, the first substrate 271 and the second substrate 272 may be electrically connected through at least one wiring member 263.

According to an embodiment, the electronic device 200 may include at least one battery 291 and 292. In an embodiment, the at least one battery 291 and 292 may include a first battery 291 disposed in the first space 2101 of the first housing 210 and electrically connected to the first substrate 271, and a second battery disposed in the second space 2201 of the second housing 220 and electrically connected to the second substrate 272. In an embodiment, the first support member 261 and the second support member 262 may further include at least one swelling hole for the first battery 291 and the second battery 292.

According to an embodiment, the first housing 210 may include a first rotation support surface 214, and the second housing 220 may include a second rotation support surface 224 corresponding to the first rotation support surface 214. In an embodiment, the first rotation support surface 214 and the second rotation support surface 224 may include curved surfaces corresponding to (naturally connected to) a curved outer surface of the hinge housing 310. In an embodiment, the first rotation support surface 214 and the second rotation support surface 224 may cover the hinge housing 310 in the case that the electronic device 200 is in an unfolded state, thereby not exposing the hinge housing 310 to the rear surface of the electronic device 200 or exposing only a portion of the hinge housing 310. In an embodiment, the first rotation support surface 214 and the second rotation support surface 224 may rotate along the curved outer surface of the hinge housing 310 to expose at least a portion of the hinge housing 310 to the rear surface of the electronic device 200 in the case that the electronic device 200 is in a folded state.

According to an embodiment, the electronic device 200 may include at least one antenna 276 disposed in the first space 2101. In an embodiment, the at least one antenna 276 may be disposed at the first battery 291 and the first rear cover 240 in the first space 2101. In an embodiment, the at least one antenna 276 may include, for example, a near field communication (NFC) antenna, a wireless charging antenna, and/or a magnetic secure transmission (MST) antenna. In an embodiment, the at least one antenna 276 may perform, for example, short-range communication with an external device or wirelessly transmit and receive power required for charging. In some embodiments, the antenna structure may be formed by at least a portion of the first lateral member 213 or the second lateral member 223 and/or a portion of the first support member 261 and the second support member 262, or a combination thereof.

According to an embodiment, the electronic device 200 may further include at least one electronic component assembly 274 and 275 and/or additional support members 273a and 273b disposed in a first space (e.g., the first space 2101 of FIG. 1A) and/or a second space (e.g., the second space 2201 of FIG. 1A). For example, the at least one electronic component assembly may include an interface connector port assembly 274 or a speaker assembly 275.

According to an embodiment, the electronic device 200 may include a first waterproof member WP1 disposed between the first reinforcing plate 4621 and the first support member 261, and a second waterproof member WP2 disposed between the second reinforcing plate 4622 and the second support member 262. In an embodiment, the first waterproof member WP1 may provide at least one first waterproof space between the first reinforcing plate 4621 and the first support member 261. In an embodiment, the at least one first waterproof space may receive an area corresponding to at least one electronic component (e.g., camera module or sensor module) disposed to be supported by the first support member 261. In an embodiment, the second waterproof member WP2 may provide a second waterproof space between the second reinforcing plate 4622 and the second support member 262. In an embodiment, the second waterproof space may receive at least a portion of a bending portion (e.g., chip on plastic (COP)) folded toward the rear surface of the first display 230.

According to an embodiment, the electronic device 200 may include a waterproof tape 241 disposed between the first rear cover 240 and the first housing 210. In an embodiment, the electronic device 200 may include a bonding member 251 disposed between the second rear cover 250 and the second housing 220. In some embodiments, the bonding member 251 may be disposed between the second display 300 and the second housing 220. In some embodiments, the waterproof tape 241 may be replaced with the bonding member 251, and the bonding member 251 may be replaced with the waterproof tape 241.

According to an embodiment, at least one hinge device 320 may include a pair of hinge devices 320 disposed at both ends in a direction parallel to the folding axis F. In some embodiments, three or more or one hinge device 320 may be disposed at a designated interval along the folding axis F. In an embodiment, the electronic device 200 may include a connection module 320-1 disposed between the hinge devices 320. In an embodiment, the connection module 320-1 may be disposed through a combination of at least one gear and/or a combination of at least one link. In some embodiments, the connection module 320-1 may be replaced with the hinge device 320. In an embodiment, the electronic device 200 may include a first hinge plate 311 and a second hinge plate 312 connected through at least one hinge device 320. In an embodiment, the first hinge plate 311 may form the same plane as that of the first housing 210 in the unfolded state, and the second hinge plate 312 may form the same plane as that of the second housing 220 in the unfolded state.

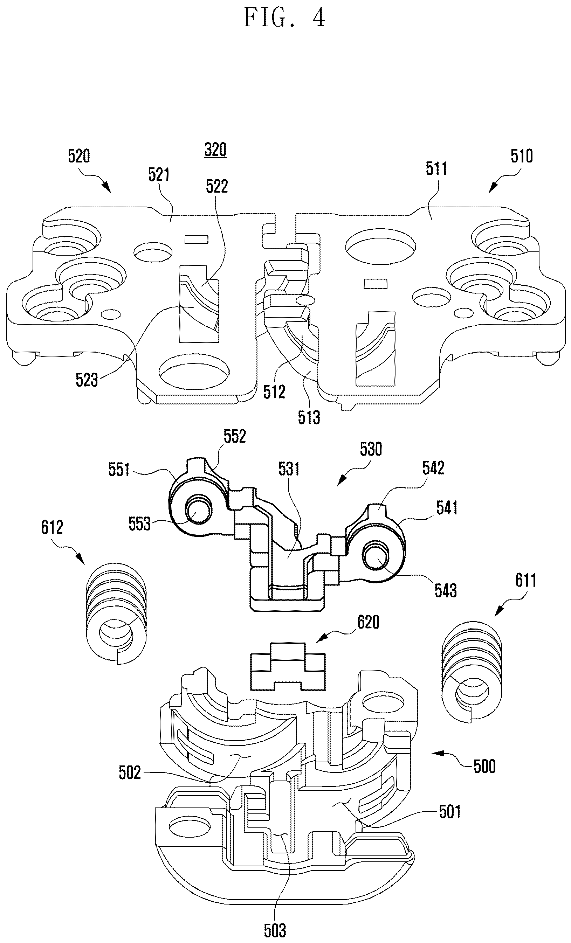

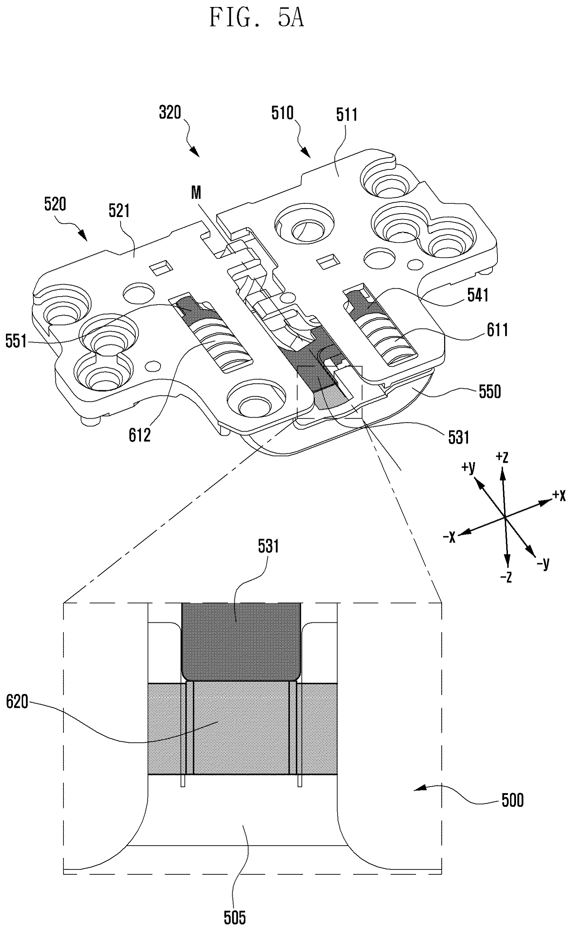

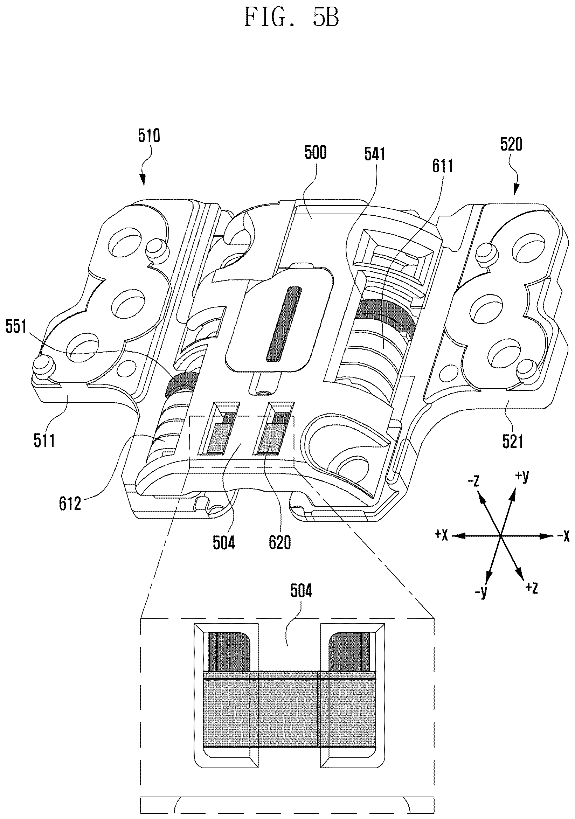

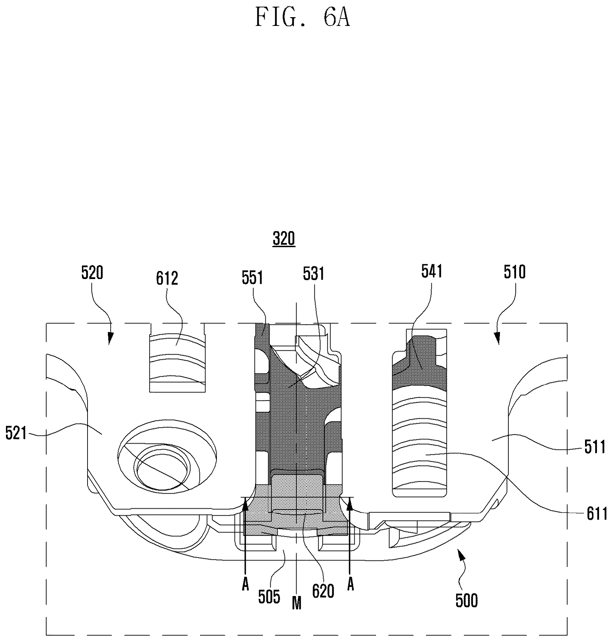

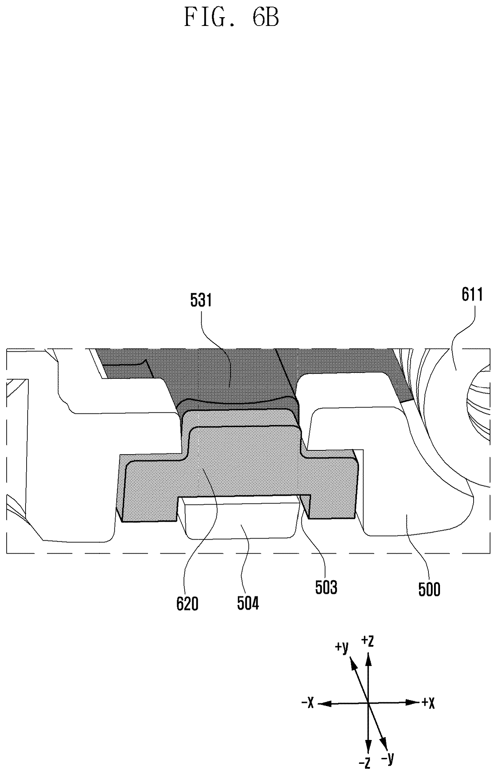

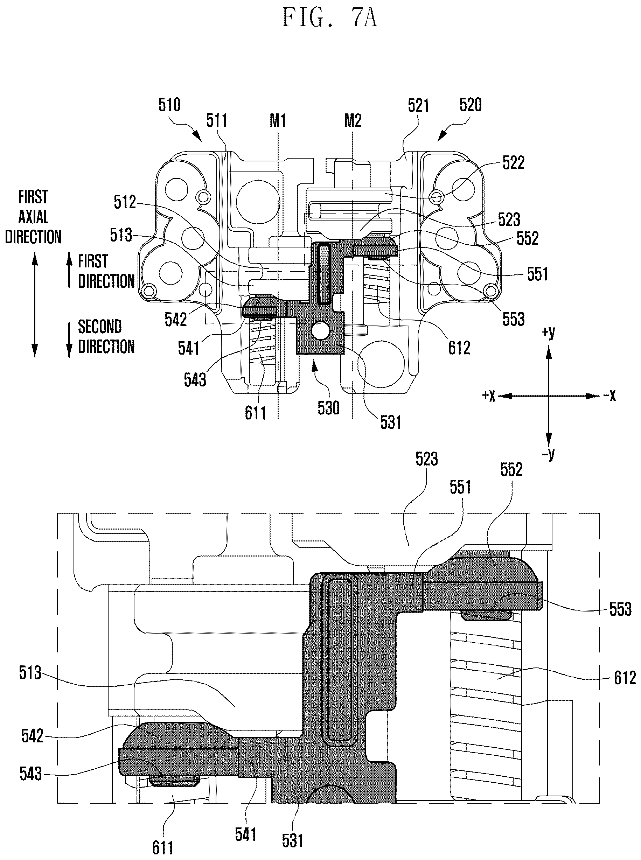

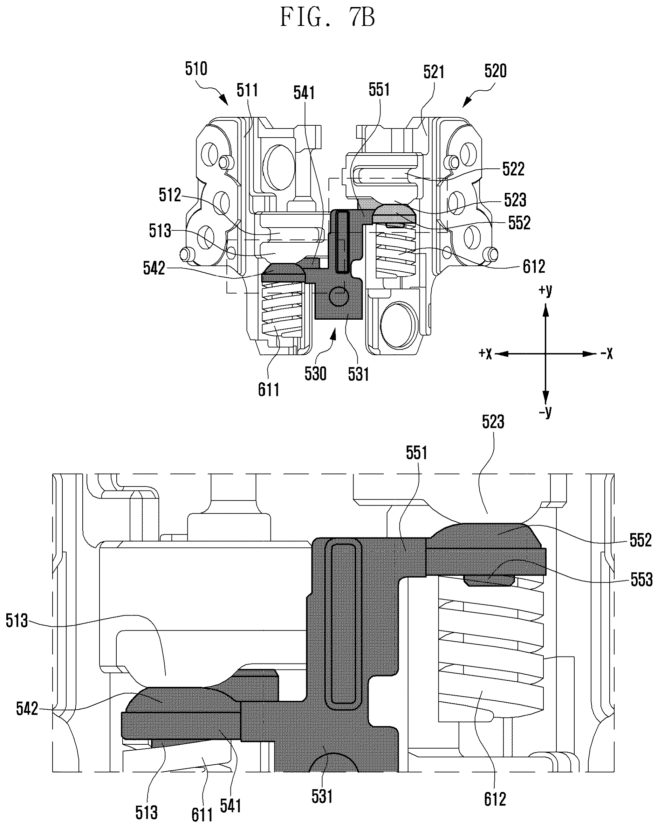

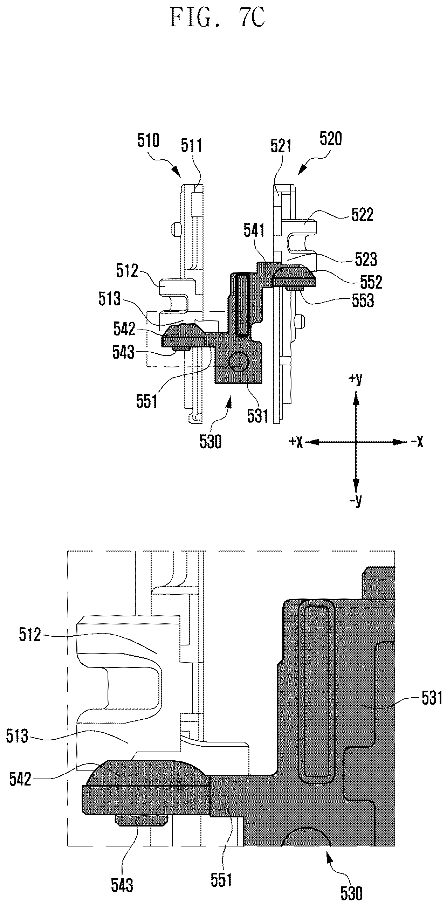

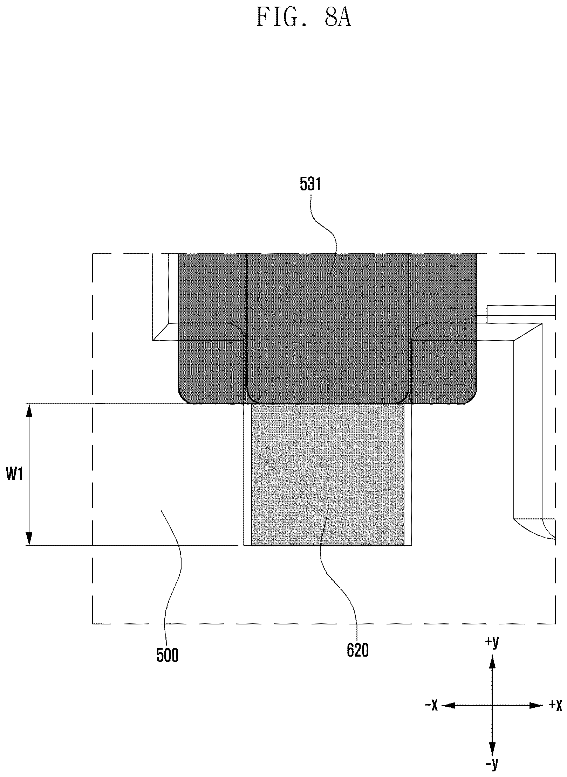

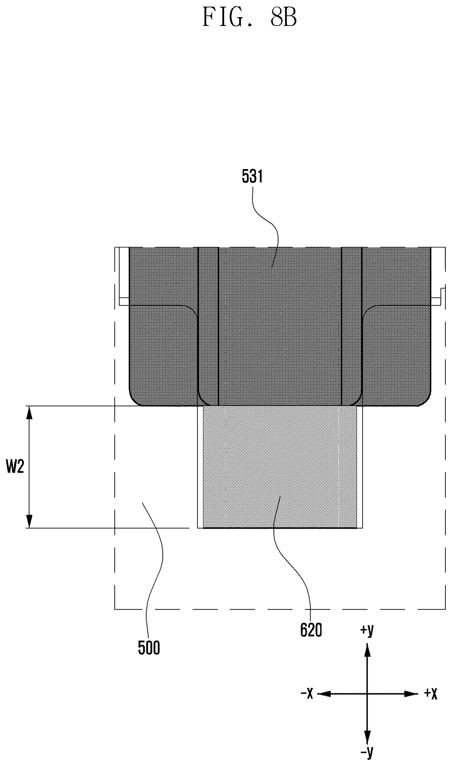

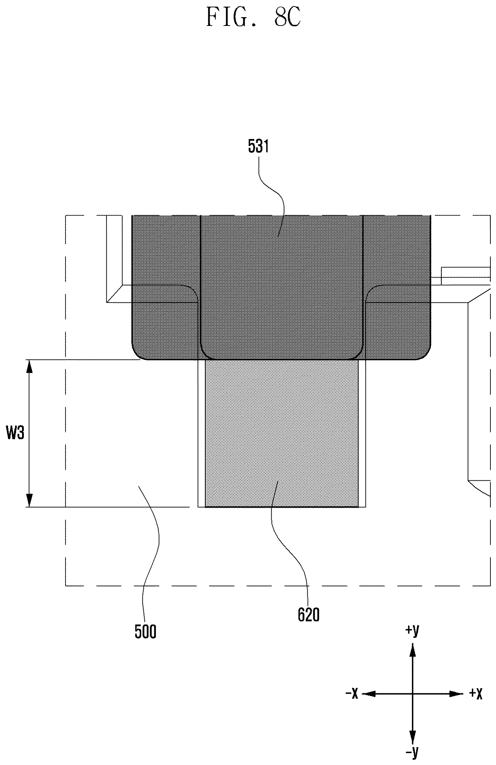

FIG. 4 is an exploded perspective view illustrating a hinge device according to an embodiment of the disclosure. FIG. 5A is a perspective view illustrating a front surface of a hinge device according to an embodiment of the disclosure. FIG. 5B is a perspective view illustrating a rear surface of a hinge device according to an embodiment of the disclosure. FIG. 6A is a diagram illustrating a coupling relationship between a cam slide and a buffer member according to an embodiment of the disclosure. FIG. 6B is a cross-sectional view taken along line A-A of FIG. 6A. FIG. 7A is a diagram illustrating the interlocking relationship between a cam part of a cam slide and a cam structure of a pair of rotators according to an unfolded state of the electronic device. FIG. 7B is a diagram illustrating the interlocking relationship between a cam part of a cam slide and a cam structure of a pair of rotators according to an intermediate state of an electronic device. FIG. 7C is a diagram illustrating the interlocking relationship between a cam part of a cam slide and a cam structure of a pair of rotators according to a folded state of an electronic device. FIG. 8A is a diagram illustrating a compression state of a buffer member according to the linear movement of the cam slide in FIG. 7A. FIG. 8B is a diagram illustrating a compression state of a buffer member according to the linear movement of the cam slide in FIG. 7B. FIG. 8C is a diagram illustrating a compression state of a buffer member according to the linear movement of the cam slide in FIG. 7C.

According to an embodiment, the first housing 210 and the second housing 220 may be foldably connected by the hinge device 320 (e.g., the hinge device 320 of FIG. 3). The hinge device 320 may be disposed between the first housing 210 and the second housing 220 to allow folding of the first housing 210 and the second housing 220.

According to an embodiment, a plurality of hinge devices 320 may be provided and disposed between the first housing 210 and the second housing 220. In an embodiment, the electronic device 200 may have a structure in which the first display 230 - the hinge device 320 - a pair of housings 210 and 220 are assembled in that order. In an embodiment, the hinge devices 320 are illustrated as two in FIG. 3 described above, but this may not limit the number of hinge devices 320. Further, the number of hinge devices 320 included in the electronic device 200 may be variously changed in consideration of the size and load-bearing capacity of the hinge devices 320.

Hereinafter, a description of the same constitution among constitutions of the hinge device 320 will be replaced with a description of one constitution without repeated description. For example, a pair of rotators 510 and 520 of the hinge device 320 will be described using a first rotator 510. A second rotator 520 is a component corresponding to the first rotator 510; thus, the description of the "first rotator 510" may be equally applied to the "second rotator 520." Further, when describing elastic members 611 and 612, the description of a second elastic member 612 may be replaced with the description of a first elastic member 611, and a second hinge arm 551 of a cam slide 530 is a component corresponding to a first hinge arm 541, and a description of the second hinge arm 551 may be replaced with the description of the first hinge arm 541.

According to an embodiment, as illustrated in FIG. 4, the hinge device 320 may include a bracket 500, a first rotator 510, a second rotator 520, a cam slide 530, elastic members 611 and 612, and/or a buffer member 620. The components of the hinge device 320 described above are merely examples, and at least one of the above-described components may be omitted as needed, and the hinge device 320 may be constituted by adding components other than these.

According to an embodiment, as illustrated in FIG. 4, the bracket 500 may be a body of the hinge device 320 to which components of the hinge device 320 may be mutually coupled. The components of the hinge device 320 may be disposed about the bracket 500 and mutually coupled or interlocked with each other. In an embodiment, the first rotator 510 and the second rotator 520 may be installed in the bracket 500 to rotate about a center M of the bracket 500. The cam slide 330 may be disposed in the bracket 500 to be interlocked with the first rotator 510 and the second rotator 520. For example, the cam slide 330 may move in a first axial direction (e.g., the first axial direction of FIG. 7A and/or Y-axis direction of FIG. 5B) in conjunction with the rotational motion of the first rotator 510 and the second rotator 520 with respect to the bracket 500. In an embodiment, the first axial direction may be a direction parallel to the folding axis F of the electronic device 200. In an embodiment, the center M of the bracket 500 may be the rotational center of the hinge device 320. Accordingly, the bracket 500 may be disposed in the first housing 210 and the second housing 220 such that the center M of the bracket 500 and the rotational center (e.g., F-axis of FIG. 1) of the electronic device 200 coincide with each other.

In an embodiment, the bracket 500 may be made of various materials. For example, the bracket 500 may be made of a metal material or a synthetic resin material. In an embodiment, the bracket 500 may be made of a material having high rigidity so as to stably support various components of the hinge device 320.

In an embodiment, as illustrated in FIG. 4, the bracket 500 may include a first coupling part 501 and a second coupling part 502. The first coupling part 501 and the second coupling part 502 may be spaced apart from each other. For example, the first coupling part 501 may be disposed in one direction with respect to the center M of the bracket 500, and the second coupling part 502 may be disposed in a direction opposite to one direction with respect to the center M of the bracket 500. In an embodiment, the first coupling part 501 may be a portion into which a first rotation part 512 of the first rotator 510 is inserted. The first rotation part 512 may be a portion of the first rotator 510 and be a portion inserted into the first coupling part 501. The second coupling part 502 may be a portion into which a second rotation part 522 of the second rotator 520 is inserted. The second rotation part 522 may be a portion of the second rotator 520 and be a portion inserted into the second coupling part 502. The first coupling part 501 may guide the rotation of the first rotation part 512 about the center M of the bracket 500. For example, the first rotation part 512 may be fastened to the first coupling part 501 to rotate about the center M of the bracket 500. Similarly, the second coupling part 502 may guide the rotation of the second rotation part 522 about the center M of the bracket 500. For example, the second rotation part 522 may be fastened to the second coupling part 502 to rotate about the center M of the bracket 500. In some embodiments, the first coupling part 501 and the second coupling part 502 may include rails (not illustrated). The first rotation part 512 may be fastened to the rail formed in the first coupling part 501 to rotate about the center M of the bracket 500. Similarly, the second rotation part 522 may be fastened to the rail formed in the second coupling part 502 to rotate about the center M of the bracket 500.

According to an embodiment, as illustrated in FIGS. 4, 5A, and 5B, the first rotator 510 may include a first plate 511 and a first rotation part 512. The second rotator 520 may include a second plate 521 and a second rotation part 522. In an embodiment, the first plate 511 and the second plate 521 may support the first display 230. The first display 230 may include a first area 230a, a second area 230b, and a third area 230c, which is a folding area positioned between the first area 230a and the second area 230b. The first area 230a, the second area 230b, and the third area 230c are conceptually divided areas of the first display 230 for description but may not be visually divided areas. The first plate 511 may support the first area 230a of the first display 230. The second plate 521 may support the second area 230b of the first display 230. As the first plate 511 and the second plate 521 rotate with respect to the bracket 500, the first area 230a and the second area 230b of the first display 230 may rotate with respect to the bracket 500. When the first area 230a and the second area 230b of the first display 230 rotate, the first area 230a and the second area 230b may be bent with respect to the third area 230c.

In an embodiment, the first rotation part 512 may be coupled to the first plate 511. For example, the first rotation part 512 may be integrally formed with the first plate 511, and in addition, the first rotation part 512 may be coupled to the first plate 511 in various coupling methods (e.g., bolt joint, rivet joint, adhesive bonding, welding joint). Similarly, the second rotation part 522 may be coupled to the second plate 521. For example, the second rotation part 522 may be integrally formed with the second plate 521, and in addition, the second rotation part 522 may be coupled to the second plate 521 in various coupling methods.

In an embodiment, as the first rotation part 512 of the first rotator 510 is rotatably fastened with respect to the bracket 500, the first plate 511 may rotate with respect to the bracket 500. As the second rotation part 522 of the second rotator 520 is rotatably fastened with respect to the bracket 500, the second plate 521 may rotate with respect to the bracket 500. The rotation of the first plate 511 with respect to the bracket 500 may be performed about a first rotational center M1 (e.g., first rotational center M1 of FIG. 7A) of the first rotation part 512. The rotation of the second plate 521 with respect to the bracket 500 may be performed about a second rotation center M2 (e.g., second rotation center M2 of FIG. 7A) of the second rotation part 522.

According to an embodiment, as illustrated in FIG. 4 and FIGS. 7A to 7C later, the cam slide 530 may include a body part 531, a first hinge arm 541 extended in one direction from the body part 531, and a second hinge arm 551 extended in a direction opposite to one direction from the body part 531. In an embodiment, the hinge arms 541 and 551 may have at least a portion of a cross-section formed in a circular shape. In an embodiment, the body part 531 may be disposed in the bracket 500 to contact the buffer member 620. The first hinge arm 541 may contact the first rotation part 512 of the first rotator 510. The second hinge arm 551 may contact the second rotation part 522 of the second rotator 520. For example, as described later, a first cam structure 513 formed in the first rotation part 512 of the first rotator 510 may engage with a first cam part 542 formed in the first hinge arm 541. Further, a second cam structure 523 formed in the second rotation part 522 of the second rotator 520 may engage with the second cam part 552 formed in the second hinge arm 551. Accordingly, as the first rotator 510 and the second rotator 520 rotate about the center M of the bracket 500, the cam slide 530 may move in the first axial direction (e.g., Y-axis direction of FIG. 7B) with respect to the bracket 500 by engaging the cam structures 513 and 523 of the rotators 510 and 520 and the cam parts 542 and 552.

In an embodiment, the bracket 500 may have a seating portion (not illustrated) on which the cam slide 530 is seated. In an embodiment, the seating portion may include a groove extended in the first axial direction so that the cam slide 530 may move in the first axial direction in conjunction with a pair of rotators 510 and 520.

According to an embodiment, a detent operation and a free stop operation may be required to increase the usability of the electronic device 200. The detent operation may be an operation of maintaining the electronic device 200 in a completely folded state or a completely unfolded state. The free stop may be an operation of maintaining the state when a certain level or higher of external force is not applied to the electronic device 200 during a process of switching from a folded state to an unfolded state or from an unfolded state to a folded state. The detent operation and the free stop operation may be implemented through the cam structures 513 and 523 formed in the rotation parts 512 and 522 of a pair of rotators 510 and 520 and the cam parts 542 and 552 of the cam slide 530 formed in a shape that engages with the cam structures 513 and 523 to be fastened to the cam structures 513 and 523.

According to an embodiment, as illustrated in FIGS. 5A, 5B, 6A, and 6B, the bracket 500 may include a seating groove 503 in which the buffer member 620 is disposed. In an embodiment, the seating groove 503 may be formed in a concave groove shape in a portion of the bracket 500. In an embodiment, the bracket 500 may include a latch jaw 504 in which the buffer member 620 is inserted and fixed. In an embodiment, the latch jaw 504 may be extended in a direction parallel to the folding axis F (e.g., Y-axis direction of FIG. 5B). The buffer member 620 may include a groove 623 formed to be fastened to the latch jaw 504. The buffer member 620 may be disposed in the bracket 500 in a state in which the groove 623 is fastened to the latch jaw 504.

In an embodiment, the buffer member 620 disposed in the seating groove 503 may have one surface contacting a part (e.g., the body part 531) of the cam slide 530 and the other surface contacting the support surface 505 of the bracket 500. Accordingly, as the pair of rotators 510 and 520 rotate, the cam slide 530 may move linearly in a first axial direction and press the buffer member 620. The buffer member 620 may be compressed and restored through the cam slide 530 and press the cam slide 530 in the first direction (e.g., +Y direction of FIG. 5A). In this case, a frictional force acting between a pair of cam parts 542 and 552 formed in the cam slide 530 and the cam structures 513 and 523 of a pair of rotators 510 and 520 may increase, thereby increasing a free stop operation in which the operation of the electronic device stops at a certain angle and/or a detent force required when the electronic device is completely folded or unfolded. Further, the buffer member 620 may diminish vibrations occurring between the cam structures 513 and 523 of the rotators 510 and 520 and the cam parts 542 and 552 of the cam slide 530.

According to an embodiment, as illustrated in FIGS. 7A, 7B, and 7C, the cam slide 530 may include a plurality of separation prevention pieces 543 and 553 that prevent the plurality of elastic members 611 and 612 from being separated from the bracket 500 during a process of contacting and moving with the cam slide 530. In an embodiment, the first hinge arm 541 of the cam slide 530 may have a first cam part 542 formed at one surface (e.g., a surface facing +Y direction based on FIG. 7A) and a first separation prevention piece 543 formed in a protruding shape at the other surface (e.g., a surface facing -Y direction based on FIG. 7A) opposite to the one surface. The first elastic member 611 may have one end supported by the support surface 505 of the bracket 500 and press the first hinge arm 541 in a first direction (e.g., +Y direction of FIG. 7A and/or the first direction of FIG. 7A) in a state in which the first separation prevention piece 543 is inserted into the other end. Similarly, the second hinge arm 551 of the cam slide 530 may have a second cam part 552 formed at one surface (e.g., a surface facing +Y direction based on FIG. 7A) and a second separation prevention piece 553 formed in a protruding shape at the other surface (e.g., a surface facing -Y direction based on FIG. 7A) opposite to the one surface. The second elastic member 612 may press the second hinge arm 551 in the first direction in a state in which one end is supported by the support surface 550 of the bracket 500 and in which the second separation prevention piece 553 is inserted into the other end. Accordingly, the phenomenon that the plurality of elastic members 611 and 612 are separated from the bracket 500 by a compressive force as they press the cam slide 530 may be prevented through the separation prevention pieces 543 and 553.

According to an embodiment, as illustrated in FIGS. 7A, 7B, and 7C, the first rotation part 512 of the first rotator 510 may include a first cam structure 513 formed at a surface (e.g., a surface facing -Y direction based on FIG. 7A) facing the first hinge arm 541 of the cam slide 530. The second rotation part 522 of the second rotator 520 may include a second cam structure 523 formed at a surface (e.g., a surface facing -Y direction based on FIG. 7A) facing the second hinge arm 551 of the cam slide 530. In an embodiment, the cam slide 530 may include a first cam part 542 formed in the first hinge arm 541 and engaging with the first cam structure 513 of the first rotation part 512, and a second cam part 552 formed in the second hinge arm 551 and engaging with the second cam structure 523 of the second rotation part 522.

According to an embodiment, as illustrated in FIGS. 7A, 7B, and 7C, the hinge device 320 may include a plurality of elastic members 611 and 612. The plurality of elastic members 611 and 612 may be disposed in the bracket 500 to press the cam slide 530 in a first direction (e.g., the first direction of FIG. 7A). In an embodiment, the first elastic member 611 may have one surface (e.g., a surface facing -Y direction based on FIG. 7A) that contacts the bracket 500, and the other surface (e.g., a surface facing +Y direction based on FIG. 7A) that presses the first hinge arm 541 of the cam slide 530 in the first direction. Accordingly, the first cam part 542 of the first hinge arm 541 may maintain a contact state with the first cam structure 513 of the first rotation part 512. Further, the second elastic member 612 may have one surface (e.g., a surface facing -Y direction based on FIG. 7A) that contacts the bracket 500 and the other surface (e.g., a surface facing +Y direction based on FIG. 7A) that presses the second hinge arm 551 of the cam slide 530 in the first direction. Accordingly, the second cam part 552 of the second hinge arm 551 may maintain a contact state with the second cam structure 523 of the second rotation part 522. Accordingly, as the cam structures 513 and 523 formed in the first rotation part 512 and the second rotation part 522 and the cam parts 542 and 552 formed in the cam slide 530 engage with each other, the electronic device 200 may perform a detent operation in a folded state and an unfolded state, and a free stop operation in an intermediate state.

As the thickness of the electronic device 200 is reduced, the thickness of the hinge device 320 may also be reduced. For example, the thickness of the elastic members 611 and 612 providing a contact force between a pair of rotators 510 and 520 and the cam slide 530 may be reduced. In this case, an elastic force of the elastic members 611 and 612 may be reduced, thereby reducing the strength pressing the cam slide 530. Accordingly, a detent operation or a free stop operation of the electronic device 200 may not be smoothly implemented. For example, a relative position of the second housing 220 with respect to the first housing 210 may not be fixed during the free stop operation. Further, a folded state or unfolded state of the electronic device 200 may not be maintained during the detent operation.

Further, in an embodiment, the hinge device 320 may generate noise or vibration due to collisions and/or steps between components during a folding operation or an unfolding operation. As described above, the hinge device 320 may be constituted such that the cam structures 513 and 523 formed in the rotation parts 512 and 522 and the cam parts 531 and 541 formed in the cam slide 530 are engaged. In the folding operation or unfolding operation of the electronic device 200, a continuous contact occurs between the cam structures 513 and 523 of the rotation parts 512 and 522 and the cam parts 542 and 552 of the cam slide 530, and in the case that the folding operation or unfolding operation of the electronic device 200 is performed with a strong force, noise and/or vibration may occur due to a collision between the cam structures 513 and 523 of the rotation parts 512 and 522 and the cam parts 542 and 552 of the cam slide 530. For example, in the case that a user performs a folding operation or an unfolding operation of the electronic device 200, a collision may occur between the cam structures 513 and 523 and the cam parts 531 and 541, resulting in noise and/or vibration. Noise and vibration generated in the hinge device 320 of the electronic device 200 may lower the operational feel of the electronic device 200 to cause discomfort to the consumer.

According to an embodiment of the disclosure, a buffer member 620 that contacts the cam slide 530 may be disposed in the bracket 500 so as to supplement a pressing force provided to the cam slide 530 by the plurality of elastic members 611 and 612. Further, the buffer member 620 may improve the operational feel of the hinge device 320 by damping vibrations generated as the cam slide 530 and the pair of rotators 510 and 520 contact. For example, the buffer member 620 may be made of a more excellent material in vibration damping than that of the elastic members 611 and 612. The relationship between the buffer member 620 and the cam slide 530 will be described in detail below.

According to an embodiment, as illustrated in FIGS. 7A to 7C, while the cam structures 513 and 523 of the rotation parts 512 and 522 and the cam parts 542 and 552 of the cam slide 530 are engaged with each other, the hinge device 320 may rotate. In an embodiment, FIG. 7A illustrates the hinge device 320 when the electronic device 200 is in an unfolded state. The hinge device 320 illustrated in FIG. 7B may be in an intermediate state in which the electronic device 200 is switched from an unfolded state to a folded state or from a folded state to an unfolded state. For example, the hinge device 320 of FIG. 7B may be in a state in which the angle between the first housing 210 and the second housing 220 is approximately 90 degrees. However, this may not limit the state illustrated in FIG. 7B to when the angle between the first housing 210 and the second housing 220 is 90 degrees. For example, the intermediate state may be formed in various angles formed by the first housing 210 and the second housing 220 in states other than the folded state and the unfolded state. FIG. 7C illustrates the hinge device 320 when the electronic device 200 is in a folded state. In an embodiment, as the pair of rotators 510 and 520 rotate with respect to the bracket 500, the cam slide 530 may move linearly in a first direction (e.g., +Y direction of FIG. 7A) or a second direction (e.g., -Y direction of FIG. 7A). The cam slide 530 may move in a first direction or a second direction in a rotational state of a pair of rotators 510 and 520 and press the elastic members 611 and 612 and the buffer member 620. The degree of pressing the elastic members 611 and 612 and the buffer member 620 may vary according to the moving direction of the cam slide 530. For example, with reference to FIG. 8A, when the electronic device 200 is in an unfolded state, the buffer member 620 may be compressed to a first length W1 by being pressed in the second direction through the body part 531 of the cam slide 530. The elastic members 611 and 612 may be compressed in the second direction by being pressed in the same direction (e.g., second direction) as that of the buffer member 620 through the hinge arms 541 and 551. In comparison, with reference to FIG. 8B, when the electronic device 200 is switched from an unfolded state to an intermediate state (e.g., a state in which the first housing 210 and the second housing 220 are at an angle of about 90 degrees), the cam slide 530 may move in a second direction (e.g., the second direction of FIG. 7A) according to interlocking of the cam parts 542 and 552 and the cam structures 513 and 523 of the rotators 510 and 520. The buffer member 620 may be compressed to the maximum in the second direction through the cam slide 530 in the intermediate state to be compressed to a second length W2 shorter than the first length W1. The elastic members 611 and 612 may be pressed in the same direction (e.g., second direction) as that of the buffer member 620 through the hinge arms 541 and 551 to be compressed in the second direction more than when the electronic device 200 is in the unfolded state. In this case, the degree to which the buffer member 620 is compressed may increase more than when the electronic device 200 is in the unfolded state; thus, the strength pressing the cam slide 530 in the first direction may increase. Accordingly, a fixing force of the free stop operation may increase. Thereafter, as the electronic device 200 is switched from the intermediate state to the folded state, the cam slide 530 may move in the first direction. The buffer member 620 may be elastically restored in the first direction by decreasing the strength pressing in the second direction through the cam slide 530 to have a third length W3 longer than the second length W2. Likewise, the elastic members 611 and 612 may be elastically restored in the first direction together with the buffer member 620. The above process may be equally applied when the electronic device 200 is switched from a folded state to an unfolded state.

In summary, the buffer member 620 may repeatedly compress and restore in the first axial direction according to a first axial movement (e.g., Y-axis direction of FIG. 8A) of the cam slide 530 with respect to the bracket 500, and press the cam slide 530 in the first direction. Further, the buffer member 620 may be disposed between the cam slide 530 and the support surface 505 of the bracket 500 together with the elastic members 611 and 612. The buffer member 620 may press the cam slide 530 in the same direction (e.g., first direction) as that of the elastic members 611 and 612. Accordingly, as the buffer member 620 is disposed in the bracket 500, a contact force between the cam structures 513 and 523 of the pair of rotators 510 and 520 and the cam parts 542 and 552 of the cam slide 530 may increase compared to when only the elastic members 611 and 612 are disposed in the bracket 500. Accordingly, a fixing force for maintaining a detent operation or a free stop operation state of the electronic device 200 may increase.

According to an embodiment, the buffer member 620 may be made of a different material from that of the elastic member. For example, the elastic members 611 and 612 may be a spring made of a metal material. Alternatively, the buffer member 620 may be made of a material capable of reducing vibration generated in the hinge device 320. For example, the buffer member 620 may be made of at least one material of rubber, urethane, silicone, thermo plastic elastomer (TPE), and thermo plastic urethane (TPU). In this case, the buffer member 620 may have a better vibration damping effect than that of the elastic members 611 and 612. Accordingly, as the buffer member 620 is disposed in the bracket 500, the vibration occurring between the cam structures 513 and 523 of a pair of rotators 510 and 520 and the cam parts 542 and 552 of the cam slide 530 may diminish compared to when only the elastic members 611 and 612 are disposed in the bracket 500.

According to an embodiment, the buffer member 620 may be formed in a shape corresponding to the cross-section of the body part 531 of the cam slide 530. For example, the buffer member 620 may be formed in a shape corresponding to a surface that contacts the body part 531. In this case, the buffer member 620 may apply an elastic force to the entire cross-section of the body part 531. Further, as the buffer member 620 contacts the entire cross-section of the body part 531, a part of the cross-section of the body part 531 may be prevented from colliding with the support surface 505 of the bracket 500.

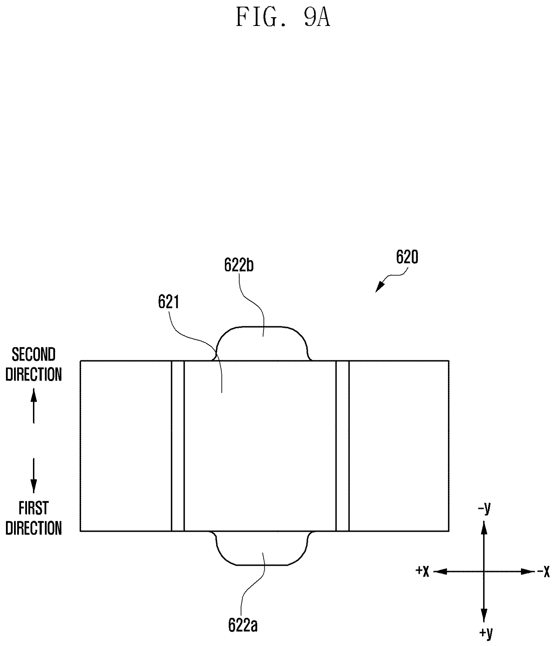

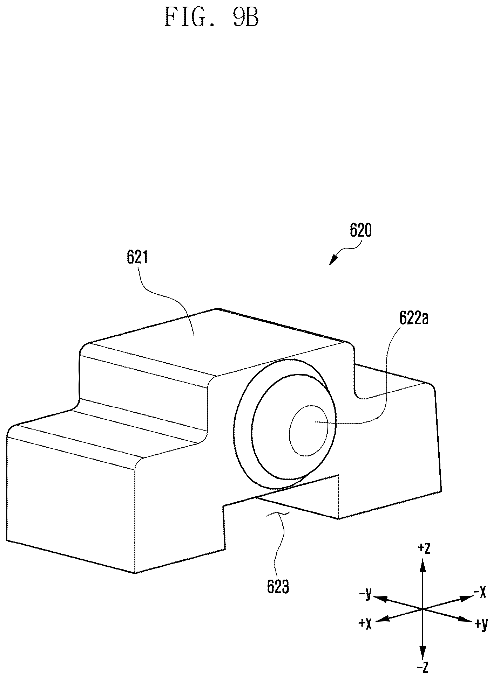

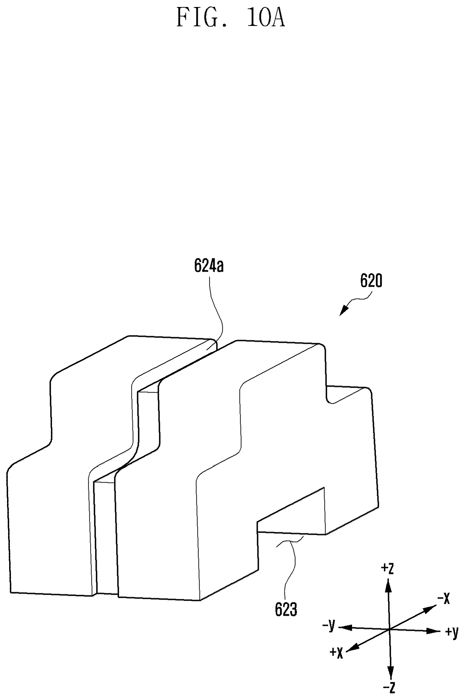

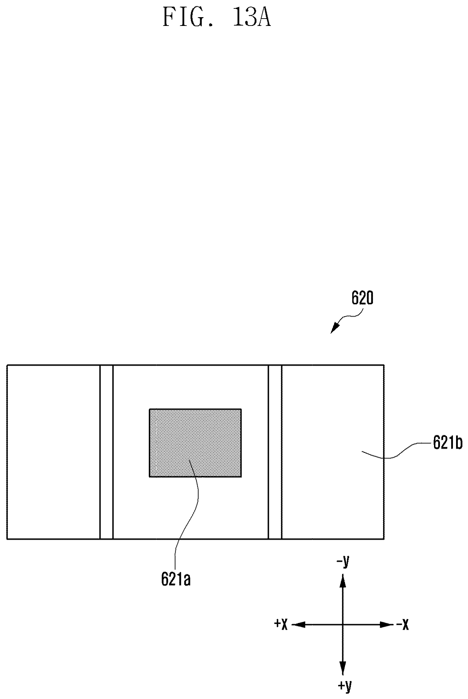

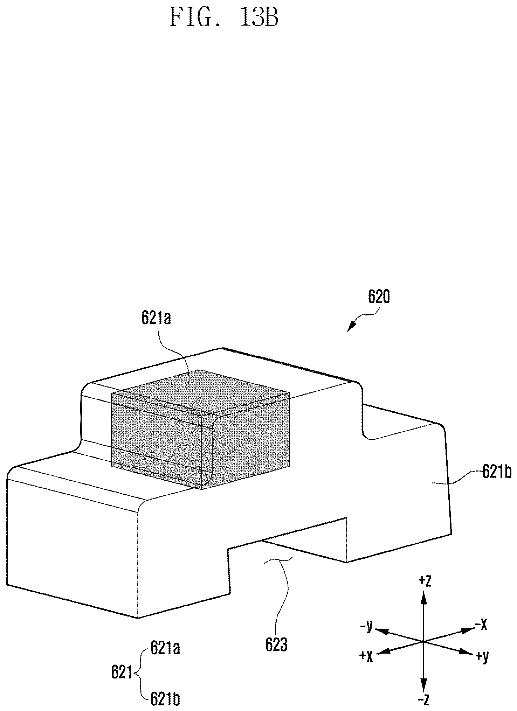

FIGS. 9A and 9B are diagrams illustrating an embodiment in which a protruding part is formed in a buffer member according to an embodiment of the disclosure. FIGS. 10A, 10B, 11A, 11B, 12A, and 12B are diagrams illustrating an embodiment in which a slit is formed in a buffer member according to an embodiment of the disclosure. FIGS. 13A and 13B are diagrams illustrating an embodiment in which an inner part and an outer part of a buffer member are made of different materials according to an embodiment of the disclosure.

According to an embodiment, as illustrated in FIGS. 9A and 9B, the buffer member 620 may include a protruding part 622 formed at one surface. In an embodiment, the buffer member 620 may include a body 621, a first protruding part 622a protruded from the body 621 in a first direction (e.g., +Y direction of FIG. 9A) to contact a body part 531 of the cam slide 530, and a second protruding part 622b protruded from the body 621 in a second direction (e.g., -Y direction of FIG. 9A) to contact the support surface 505 of the bracket 500 of the cam slide 530. In an embodiment, the buffer member 620 may increase a pressing force against the cam slide 530 through the protruding part 622. For example, in the case that the first protruding part 622a and the second protruding part 622b extended in the first direction and the second direction, respectively, within the limited space of the bracket 500 are formed in the buffer member 620, a space occupied by the buffer member 620 within the bracket 500 may be expanded in the first axial direction (e.g., Y-axis direction of FIG. 9A). The cam slide 530 may move in the first direction as much as the space occupied by the buffer member 620 is expanded. Accordingly, a contact force acting between the cam parts 542 and 552 of the cam slide 530 and the cam structures 513 and 523 of the rotators 510 and 520 increases; thus, a free stop operation and/or a detent force required when the electronic device is completely folded or unfolded may increase.

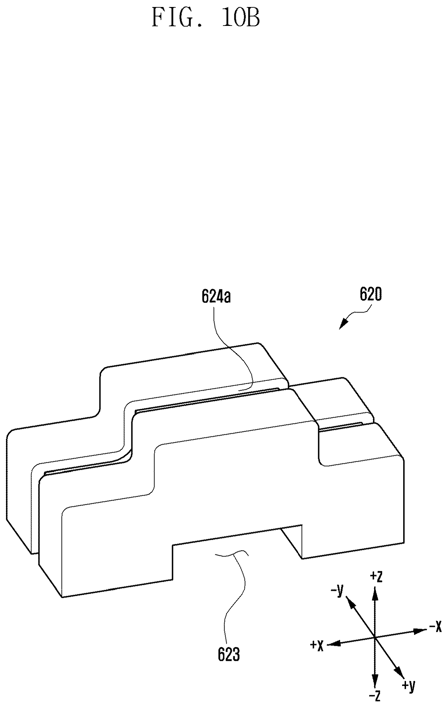

According to an embodiment, the buffer member 620 may generate an elastic force through contact with the body part 531 of the cam slide 530, and be repeatedly compressed and restored. In this case, as an elastic force is repeatedly applied in a first axial direction (e.g., Y-axis direction of FIG. 10A), a shape of the buffer member 620 may be deformed. According to an embodiment of the disclosure, as illustrated in FIGS. 10A and 10B, the buffer member 620 forms a first slit 624a in a second axial direction (e.g., X-axis direction of FIG. 10A) perpendicular to the first axial direction in which the elastic force applies; thus, deformation of the buffer member 620 according to the elastic force applied in the first axial direction may be prevented or reduced. In an embodiment, the first slit 624a may be formed at a side surface enclosing a front surface of the body 621 facing a first direction (e.g., +Y direction of FIG. 10A) and a rear surface of the body 621 facing a second direction (e.g., -Y direction of FIG. 10B).

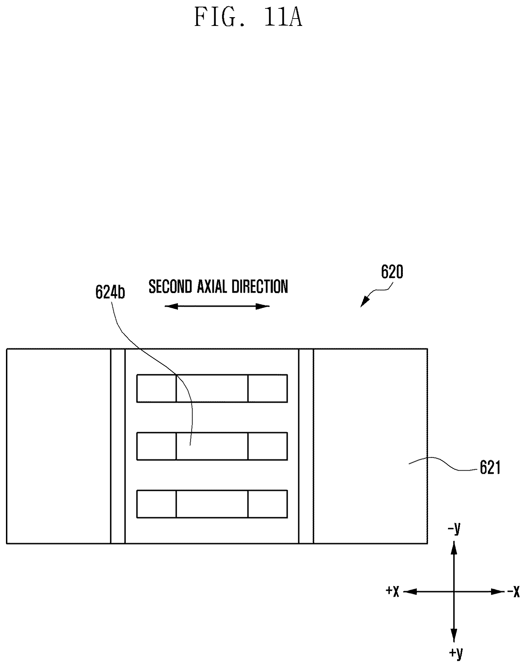

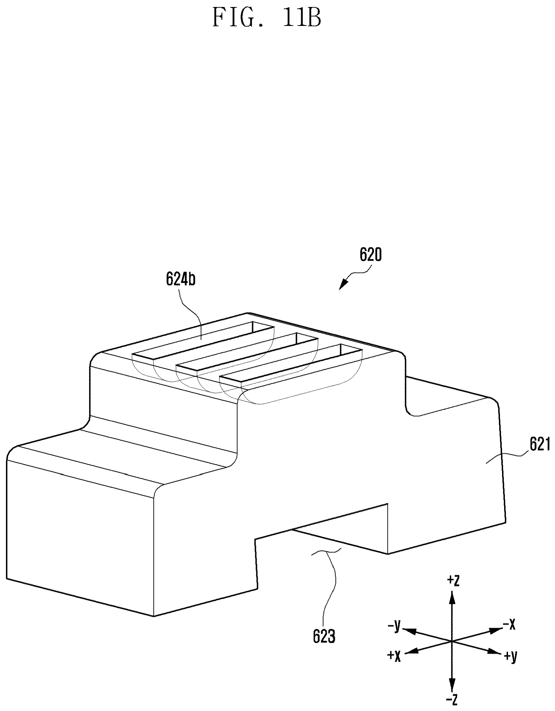

According to an embodiment, as illustrated in FIGS. 11A and 11B, the buffer member 620 may include at least one second slit 624b formed in the body 621 in a second axial direction (e.g., the second axial direction of FIG. 11A and/or X-axis direction of FIG. 11A). In an embodiment, the second slit 624b may be formed in a portion of a side surface of the body 621. In an embodiment, in the case that the buffer member 620 is compressed in the second direction (e.g., -Y direction of FIG. 11A) through the cam slide 530, the buffer member 620 may be compressed further by the space in which the second slit 624b is formed. In this case, the strength pressing the cam slide 530 may be reduced compared to before the second slit 624b is formed. Accordingly, by forming the second slit 624b in the buffer member 620, a contact force acting between the cam parts 542 and 552 of the cam slide 530 and the cam structures 513 and 523 of the rotators 510 and 520 may be adjusted.

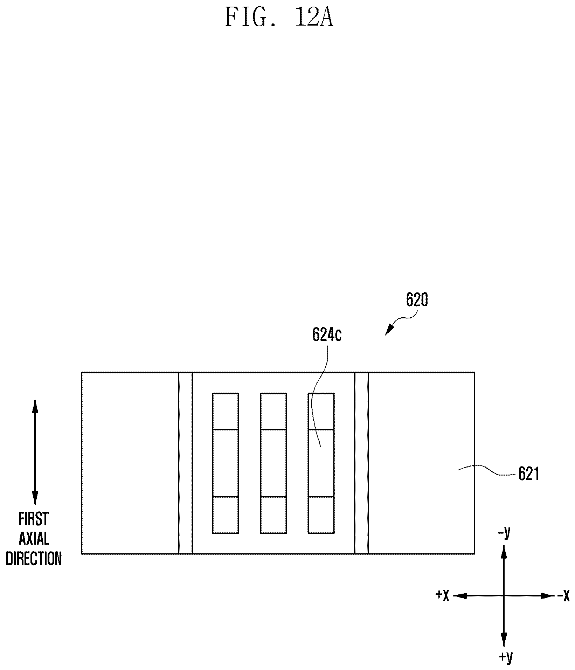

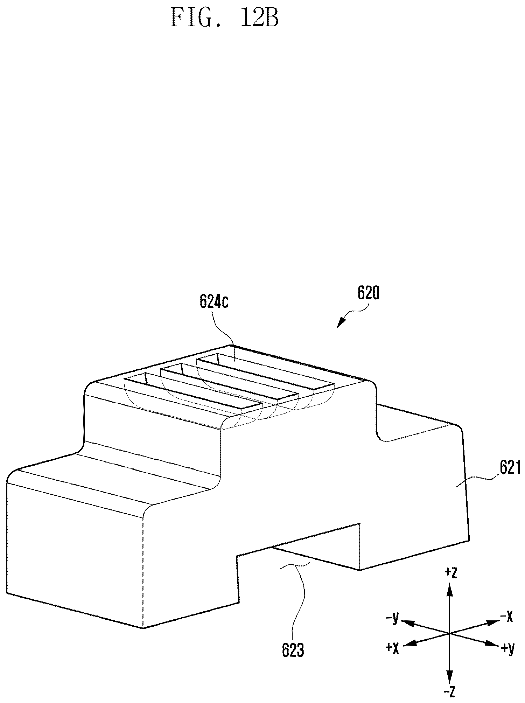

According to an embodiment, as illustrated in FIGS. 12A and 12B, the buffer member 620 may include at least one third slit 624c formed in the body 621 in a first axial direction (e.g., the first axial direction of FIG. 12A and/or Y-axis direction of FIG. 12A). In an embodiment, the third slit 624c may be formed in a portion of a side surface of the body 621. In an embodiment, the buffer member 620 may press the cam slide 530 with reduced intensity compared to before the third slit 624c is formed, but may press the cam slide 530 with increased intensity compared to in the case that the second slit 624b is formed, as illustrated in FIGS. 11A and 11B described above. Accordingly, a contact force acting between the cam parts 542 and 552 of the cam slide 530 and the cam structures 513 and 523 of the rotators 510 and 520 may be adjusted through the third slit 624c in the buffer member 620.

According to an embodiment, as illustrated in FIGS. 13A and 13B, the body 621 of the buffer member 620 may include an inner part 621a positioned at the inner side of the body 621 and an outer part 621b enclosing the inner part 621a and forming an outer appearance of the body 621. In an embodiment, the inner part 621a and the outer part 621b of the buffer member 620 may be made of different materials. For example, the inner part 621a and the outer part 621b may be made of materials having different elastic coefficients. In an embodiment, the inner part 621a may be made of a material having a lower elastic coefficient than that of the outer part 621b. Conversely, in an embodiment, the inner part 621a may be made of a material having a higher elastic coefficient than that of the outer part 621b. The buffer member 620 may adjust the strength pressing the cam slide 530 by forming the inner part 621a and the outer part 621b with different materials. Therefore, a contact force acting between the cam parts 542 and 552 of the cam slide 530 and the cam structures 513 and 523 of the rotators 510 and 520 may be adjusted as the buffer member 620 is made of different materials. According to an embodiment, the inner part 621a of the buffer member 620 may include rubber, urethane, silicone, thermo plastic elastomer (TPE), thermo plastic urethane (TPU), a polymer material, and/or metal (e.g., iron, stainless steel). For example, the inner part 632a may include a plate spring and/or a coil spring.

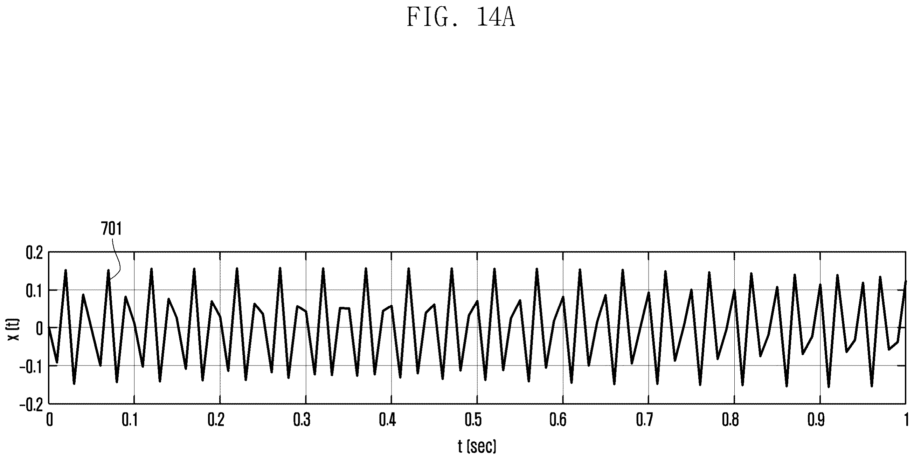

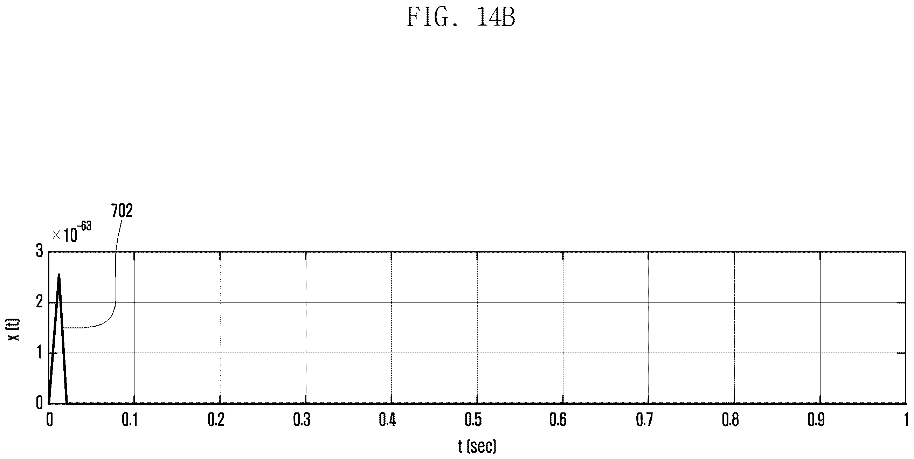

FIG. 14A is a graph illustrating vibrations occurring in a hinge device in a state in which no buffer member is disposed in the hinge device according to an embodiment of the disclosure. FIG. 14B is a graph illustrating vibrations occurring in a hinge device in a state in which a buffer member is disposed in the hinge device according to an embodiment of the disclosure.

According to an embodiment, FIG. 14A is a graph 701 illustrating vibrations generated when a cam slide 530 and a pair of rotators 510 and 520 contact each other in a state where a buffer member 620 is not disposed in the bracket 500. FIG. 14B is a graph 702 illustrating vibrations generated when a cam slide 530 and a pair of rotators 510 and 520 contact each other in a state where a buffer member 620 is disposed in the bracket 500. In an embodiment, in the case that a buffer member 620 is not disposed in the bracket 500, it may be identified that minute vibrations are continuously generated per hour, as illustrated in FIG. 14A. Alternatively, in the case that a buffer member 620 is disposed between the cam slide 530 and the support surface 505 of the bracket 500, as illustrated in FIG. 14B, it may be identified that most of the vibration generated by interlocking of the cam slide 530 and the rotators 510 and 520 diminishes compared to FIG. 14A. Accordingly, the buffer member 620 may improve the operational feel of the hinge device 320 by attenuating the vibration generated by the contact between the cam slide 530 and the pair of rotators 510 and 520.

According to an embodiment of the disclosure, the hinge device 320 may include a bracket 500 including a first coupling part 501 and a second coupling part 502 spaced apart from the first coupling part, a first rotator 510 including a first rotation part 512 fastened to the first coupling part of the bracket to rotate with respect to the bracket, and a first cam structure 513 formed in the first rotation part, a second rotator 520 including a second rotation part 522 fastened to the second coupling part of the bracket to rotate with respect to the bracket, and a second cam structure 523 formed in the second rotation part, a first cam part 542 disposed in the bracket and engaging with the first cam structure, a second cam part 552 engaging with the second cam structure, a cam slide 530 moving in a first axial direction (e.g., the first axial direction of FIG. 7A and/or Y-axis direction of FIG. 7A) according to the rotation of the first rotator and the second rotator, elastic members 611 and 612 disposed between one surface of the bracket and the cam slide to press the cam slide in a first direction (e.g., the first direction of FIG. 7A and/or +Y-axis direction of FIG. 7A), and a buffer member 620 made of a material different from that of the elastic member and disposed between one surface of the bracket and the cam slide to press the cam slide in the first direction.

Further, the cam slide may include a body part 531, a first hinge arm 541 in which the first cam part is formed, and a second hinge arm 551 in which the second cam part is formed, and the elastic members 611 and 612 may be disposed between one surface of the bracket and the first hinge arm and between one surface of the bracket and the second hinge arm, and the buffer member 620 may be disposed between one surface of the bracket and the body part.

Further, the first hinge arm may have a portion of a cross-section formed in a circular shape, the first cam part may be formed at one surface of the first hinge arm, and the elastic member may contact the other surface opposite to the one surface of the first hinge arm, and the second hinge arm may have a portion of a cross-section formed in a circular shape, the second cam part may be formed at one surface of the second hinge arm, and the elastic member may contact the other surface opposite to the one surface of the second hinge arm.

Further, the elastic member and the buffer member may move in the first axial direction according to the rotation of the first rotator and the second rotator and press the cam slide in the first direction (e.g., the first direction of FIG. 7A and/or +Y direction of FIG. 7A).

Further, the buffer member may be formed in a shape corresponding to one surface of the body part of the cam slide contacting the buffer member.

Further, the bracket may include a seating groove 503 into which the buffer member is inserted.

Further, the bracket may include a latch jaw 504 extended in a direction parallel to a folding axis F of the hinge device, and the buffer member may include a groove 623 fastened to the latch jaw.

Further, the buffer member may include at least one slit 624a and 624b extended in a second axial direction perpendicular to the first axial direction.

Further, the buffer member may include at least one slit 624c formed in the first axial direction.

Further, the buffer member may include a body 621, a first protruding part 622a protruded from the body in a first direction (e.g., the first direction of FIG. 9A and/or +Y direction of FIG. 9A) to contact the body part of the cam slide, and a second protruding part 622b protruded from the body in a second direction (e.g., the second direction of FIG. 9A and/or -Y direction of FIG. 9A) opposite to the first direction to contact one surface of the bracket.

Further, the buffer member may include an inner part 621a located at the inside and an outer part 621b made of a material having a different elastic coefficient from that of the inner part and enclosing the inner part.

Further, the buffer member may be made of a material in which the inner part has a lower elastic modulus than that of the outer part.

Further, the buffer member may be made of at least one material of rubber, urethane, silicone, thermo plastic elastomer (TPE), and thermo plastic urethane (TPU).

According to an embodiment of the disclosure, an electronic device 200 may include a first housing 210, a second housing 220, and a hinge device 320 configured to foldably connect the first housing and the second housing, wherein the hinge device may include a bracket 500 including a first coupling part 501 and a second coupling part 502 spaced apart from the first coupling part, a first rotator 510 including a first rotation part 512 fastened to the first coupling part of the bracket to rotate with respect to the bracket, and a first cam structure 513 formed in the first rotation part, a second rotator 520 including a second rotation part 522 fastened to the second coupling part of the bracket to rotate with respect to the bracket, and a second cam structure 523 formed in the second rotation part, a cam slide 530 including a first cam part 542 disposed in the bracket and configured to engage with the first cam structure, and a second cam part 552 configured to engage with the second cam structure and moving in a first axial direction (e.g., the first axial direction of FIG. 7A and/or Y-axis direction of FIG. 7A) according to the rotation of the first rotator and the second rotator, elastic members 611 and 612 disposed between one surface of the bracket and the cam slide to press the cam slide in a first direction (e.g., the first direction of FIG. 7A and/or + Y-axis direction of FIG. 7A), and a buffer member 620 made of a different material from that of the elastic members and disposed between one surface of the bracket and the cam slide to press the cam slide in the first direction.

Further, the cam slide may include a body part 531, a first hinge arm 541 in which the first cam part is formed, and a second hinge arm 551 in which the second cam part is formed, the elastic members 611 and 612 may be disposed between one surface of the bracket and the first hinge arm and between one surface of the bracket and the second hinge arm, and the buffer member 620 may be disposed between one surface of the bracket and the body part.

Further, the first hinge arm may have a portion of a cross-section formed in a circular shape, the first cam part may be formed at one surface of the first hinge arm, the elastic member may contact the other surface opposite to the one surface of the first hinge arm, the second hinge arm may have a portion of a cross-section formed in a circular shape, the second cam part may be formed at one surface of the second hinge arm, and the elastic member may contact the other surface opposite to the one surface of the second hinge arm.

Further, the buffer member may be formed in a shape corresponding to one surface of the body part of the cam slide contacting the buffer member.

Further, the buffer member may include at least one slit 624a and 624b extended in a second axial direction perpendicular to the first axial direction.

Further, the buffer member may include at least one slit 624c formed in the first axial direction.

Further, the buffer member may include a body 621, a first protruding part 622a protruded from the body in a first direction (e.g., the first direction of FIG. 9A and/or +Y direction of FIG. 9A) to contact the body part of the cam slide, and a second protruding part 622b protruded from the body in a second direction (e.g., the second direction of FIG. 9A and/or -Y direction of FIG. 9A) opposite to the first direction to contact one surface of the bracket.

Further, the buffer member may include an inner part 621a located at the inside and an outer part 621b enclosing the inner part, and the outer part may be made of a material having a lower elastic modulus than that of the inner part.

## Claims

1. A hinge device 320, comprising:
a bracket 500 including a first coupling part 501 and a second coupling part 502 spaced apart from the first coupling part;
a first rotator 510 including a first rotation part 512 fastened to the first coupling part of the bracket to rotate with respect to the bracket, and a first cam structure 513 formed in the first rotation part;
a second rotator 520 including a second rotation part 522 fastened to the second coupling part of the bracket to rotate with respect to the bracket, and a second cam structure 523 formed in the second rotation part;
a cam slide 530 including a first cam part 542 disposed in the bracket and configured to engage with the first cam structure and a second cam part 552 configured to engage with the second cam structure, and configured to move in a first axial direction according to the rotation of the first rotator and the second rotator;
elastic members 611 and 612 disposed between one surface of the bracket and the cam slide to press the cam slide in the first direction; and
a buffer member 620 made of a material different from that of the elastic member and disposed between one surface of the bracket and the cam slide to press the cam slide in the first direction.

2. The hinge device of claim 1, wherein the cam slide comprises a body part 531, a first hinge arm 541 in which the first cam part is formed, and a second hinge arm 551 in which the second cam part is formed,
the elastic members 611 and 612 are disposed between one surface of the bracket and the first hinge arm and between one surface of the bracket and the second hinge arm, and
the buffer member 620 is disposed between one surface of the bracket and the body part.

3. The hinge device of claim 2, wherein the first hinge arm has a part of a cross-section formed in a circular shape, the first cam part is formed at one surface of the first hinge arm, and the elastic member is configured to contact the other surface opposite to the one surface of the first hinge arm, and
the second hinge arm has a part of a cross-section formed in a circular shape, the second cam part is formed at one surface of the second hinge arm, and the elastic member is configured to contact the other surface opposite to the one surface of the second hinge arm.

4. The hinge device of claim 2, wherein the buffer member is formed in a shape corresponding to one surface of the body part of the cam slide contacting the buffer member.

5. The hinge device of claim 1, wherein the bracket comprises a seating groove 503 into which the buffer member is inserted.

6. The hinge device of claim 1, wherein the bracket comprises a latch jaw 504 extended in a direction parallel to a folding axis F of the hinge device, and
the buffer member comprises a groove 623 fastened to the latch jaw.

7. The hinge device of claim 1, wherein the buffer member comprises at least one slit 624a and 624b extended in a second axial direction perpendicular to the first axial direction.

8. The hinge device of claim 1, wherein the buffer member comprises at least one slit 624c formed in the first axial direction.

9. The hinge device of claim 2, wherein the buffer member comprises a body 621, a first protruding part 622a protruded from the body in a first direction to contact the body part of the cam slide, and a second protruding part 622b protruded from the body in a second direction opposite to the first direction to contact one surface of the bracket.

10. The hinge device of claim 1, wherein the buffer member comprises an inner part 621a located at the inside and an outer part 621b configured to enclose the inner part and made of a material having a different elastic coefficient from that of the inner part.

11. The hinge device of claim 10, wherein the buffer member is made of a material in which the inner part has a lower elastic modulus than that of the outer part.

12. An electronic device 200, comprising:
a first housing 210;
a second housing 220; and
a hinge device 320 configured to foldably connect the first housing and the second housing,
wherein the hinge device comprises:
a bracket 500 including a first coupling part 501 and a second coupling part 502 spaced apart from the first coupling part;
a first rotator 510 including a first rotation part 512 fastened to the first coupling part of the bracket to rotate with respect to the bracket, and a first cam structure 513 formed in the first rotation part;
a second rotator 520 including a second rotation part 522 fastened to the second coupling part of the bracket to rotate with respect to the bracket, and a second cam structure 523 formed in the second rotation part;
a cam slide 530 including a first cam part 542 disposed in the bracket and configured to engage with the first cam structure and a second cam part 552 configured to engage with the second cam structure, and configured to move in a first axial direction according to the rotation of the first rotator and the second rotator;
elastic members 611 and 612 disposed between one surface of the bracket and the cam slide to press the cam slide in a first direction; and
a buffer member 620 made of a material different from that of the elastic member and disposed between one surface of the bracket and the cam slide to press the cam slide in the first direction.

13. The electronic device of claim 12, wherein the cam slide comprises a body part 531, a first hinge arm 541 in which the first cam part is formed, and a second hinge arm 551 in which the second cam part is formed,
the elastic members 611 and 612 are disposed between one surface of the bracket and the first hinge arm and between one surface of the bracket and the second hinge arm, and
the buffer member 620 is disposed between one surface of the bracket and the body part.

14. The electronic device of claim 12, wherein the buffer member comprises at least one slit 624a and 624b extended in a second axial direction perpendicular to the first axial direction.

15. The electronic device of claim 13, wherein the buffer member comprises a body 621, a first protruding part 622a protruded from the body in a first direction to contact the body part of the cam slide, and a second protruding part 622b protruded from the body in a second direction opposite to the first direction to contact one surface of the bracket.
